# EUROPÄISCHE PATENTSCHRIFT

(11) **EP 2 882 607 B1**
(45) Veröffentlichungstag und Bekanntmachung des Hinweises auf die Patenterteilung: **12.10.2016**
(21) Anmeldenummer: 13788663.6
(22) Anmeldetag: 07.08.2013
(51) Int. Cl.: B60L 11/18

(54) **LADEANSCHLUSSVORRICHTUNG FÜR ELEKTROFAHRZEUGE**
CHARGE CONNECTING DEVICE FOR ELECTRIC VEHICLES
DISPOSITIF DE BRANCHEMENT POUR CHARGE POUR DES VÉHICULES ÉLECTRIQUES

(30) Priorität: 09.08.2012 DE 202012102992 U
(43) Veröffentlichungstag der Anmeldung: 17.06.2015
(73) Patentinhaber: KEBA AG, 4041 Linz (AT)
(72) Erfinder: STARZINGER, Reinhard Gottlieb, A-4040 Linz (AT); WEIDINGER, Gerhard, A-4614 Marchtrenk (AT)
(74) Vertreter: Burger, Hannes
(86) Internationale Anmeldenummer: PCT/AT2013/050155
(87) Internationale Veröffentlichungsnummer: WO 2014/022874

(56) Entgegenhaltungen:
- US-A1- 2010 013 433
- US-A1- 2010 013 434
- US-A1- 2011 172 839
- US-A1- 2012 116 745

## Beschreibung

Die Erfindung betrifft eine Ladeanschlussvorrichtung für Elektrofahrzeuge, wie sie im Anspruch 1 angegeben ist.

Es ist allgemein bekannt, dass zum Aufladen bzw. Regenerieren des Energiespeichers eines elektrisch betriebenen Fahrzeuges ein solches Fahrzeug für eine gewisse Zeit abgestellt und mit einer elektrischen Energiequelle, üblicherweise dem örtlich vorhandenen Stromnetz, elektrisch verbunden wird. Moderne elektrische Fahrzeuge haben dabei mittlerweile eine akzeptable Reichweite von mehreren 100km, die mit einem voll aufgeladenen Energiespeicher zurückgelegt werden können, und weiters eine entsprechend hohe Antriebsleistung in der Größenordnung von bis zu 100kW, was eine komfortable und rasche Fortbewegung ermöglicht.

Im Vergleich zu Fahrzeugen, welche Verbrennungskraftmaschinen für den Antrieb nutzen und während nur sehr kurzer Stillstandszeit in der Regel mit einem flüssigen oder gasförmigen Energieträger betankt werden, dauert der Ladevorgang der heute für Elektrofahrzeuge üblichen elektrochemischen Energiespeicher relativ lange. Um die Einsatzzeit bzw. Verfügbarkeit eines elektrischen Fahrzeuges zu verbessern, wird daher danach getrachtet, die Ladezeit möglichst kurz zu halten, wofür jedoch während dem Ladevorgang eine erhebliche elektrische Leistung benötigt wird. Diese muss vom elektrischen Netz bezogen, typischerweise über die Ladeelektronik im Fahrzeug umgewandelt und schließlich in den Energiespeicher des Fahrzeuges übertragen werden. Die Größenordnung der Ladeleistung liegt heute im Bereich bis zu etwa 22kW und ist damit deutlich höher als die elektrische Leistung, die beispielsweise von einer üblichen Haushaltssteckdose bezogen werden kann. Elektrisch betriebene Kraftfahrzeuge stellen also im Vergleich zu anderen in Haushalten üblichen, elektrischen Verbrauchern durchaus Großverbraucher dar. Selbst wenn ein Stromanschluss mit prinzipiell ausreichend hoher elektrischer Anschlussleistung zur Verfügung steht, kann es aufgrund der Gesamtbelastung in Teilen des Stromnetzes zu zeit- oder situationsabhängigen Einschränkungen bei der tatsächlich verfügbaren Leistung kommen.

Für den Ladevorgang elektrischer Kraftfahrzeuge - soweit es sich nicht um Kleinfahrzeuge in der Art eines Elektrofahrrades oder um Vergleichbares handelt - sind daher spezielle Ladeanschlussvorrichtungen erforderlich oder zumindest zweckmäßig, welche im Gegensatz zu einer herkömmlichen Steckdose nicht nur eine entsprechend hohe elektrische Anschlussleistung bereitstellen bzw. übertragen können, sondern auch zusätzliche Kommunikationsmittel aufweisen, mit denen die Ladeelektronik eines angeschlossenen Fahrzeuges die tatsächlich jeweils beziehbare Ladeleistung ermitteln kann bzw. auf die aktuelle Netzsituation reagieren kann, ohne das Netz bzw. die Zuleitung zu überlasten und damit eine Abschaltung zu verursachen. Weiters sind in solchen Ladeanschlussvorrichtungen eine Reihe von Sicherheitseinrichtungen implementiert, beispielsweise eine Sperrvorrichtung, die ein unbefugtes Abstecken oder ein Abstecken unter Volllast mit entsprechender Lichtbogenbildung verhindert. Die entsprechenden Ladeanschlussvorrichtungen sorgen typischerweise auch dafür, dass beim Auftreten von Fehlerströmen, bei Überlast und fallweise bei unzulässigen Rückspeiseströmen abgeschaltet bzw. entsprechend signalisiert wird.

Solche Ladeanschlussvorrichtungen können darüber hinaus Mittel zur Autorisierung des Energiebezugs beinhalten, beispielsweise via einen kodierten RFID-Transponder oder via einen Schlüsselschalter, oder technische Mittel umfassen, um den Benutzer zu identifizieren bzw. um Informationen für Verrechnungszwecke zu erfassen und gegebenenfalls diese Daten über datentechnische Netzwerkverbindungen mit zentralen Clearing-Stellen auszutauschen. Weiters können solche Ladeanschlussvorrichtungen auch Mittel zur Messung und Überwachung der übertragenen Leistung, des Stromes, oder der Energiemenge beinhalten. Der Stromanschluss, sowohl netzseitig als auch fahrzeugseitig, ist aufgrund der hohen zu übertragenden Leistung in der Regel als dreiphasiger bzw. mehrphasiger Starkstromanschluss mit entsprechend großen Leitungsquerschnitten von typisch 4 bis 6 mm², fallweise aber auch mit bis zu 16 mm² ausgeführt. Zweckmäßigerweise sind die Ladeanschlussvorrichtungen in unmittelbarer Nähe zu den Abstellplätzen der jeweiligen Elektrofahrzeuge installiert, wobei es sich üblicherweise um Garagen, Tiefgaragen, überdachte Parkflächen und dergleichen handelt, welche privat, fallweise aber auch öffentlich zugänglich oder zumindest für eine größeren Personenkreis zugänglich sein können.

Derartige Ladeanschlussvorrichtungen werden beispielsweise in den Druckschriften US 4,532,418 A, DE 42 13 414 C2, FR 2 766 950 A1, JP 11-122714 A, US 6,362,594 B2, WO 2007/141543 A2, WO 2010/011545 A1, WO 2010/133959 A2 und AT 507 605 A1 beschrieben.

Die US 2011/0172839 A1 offenbart eine Ladeanschlussvorrichtung für Elektrofahrzeuge, in welcher eine Mehrzahl von Überprüfungs- und Testmaßnahmen in Bezug auf Schutzerdung und Fehlerstromüberwachung implementiert sind. Diese Schutzmaßnahmen sind dabei - wie an sich bekannt - automatisch oder manuell zu aktivieren, um einen personensicheren Zustand der Ladestation überprüfen zu können. Zudem ist eine Zeitschaltvorrichtung implementiert, welche in Abhängigkeit von variierenden Energiekosten eine Aktivierung und Deaktivierung bzw. eine Programmierung der Ladevorrichtung erlaubt. Diese Zeitschaltvorrichtung kann dabei auch eine kalenderabhängige Schaltfunktionalität umfassen.

Die US 2010/0013434 A1 bzw. die äquivalente, oben genannte WO 2007/141543 A2 beschreibt eine Ladestation, insbesondere eine Ladesäule, welche speziell zur Positionierung an öffentlichen Plätzen, wie zum Beispiel Gehsteigen oder Parkflächen vorgesehen ist. Diese Ladesäule umfasst eine Ladeschnittstelle, insbesondere eine Standardsteckbuchse, welche mittels einer elektronisch gesteuerten, elektromagnetisch entriegelbaren Schutzklappe vor allgemeinem Zugriff geschützt ist. Die entsprechende Schutzklappe ist dabei mittels einem Scharnier an der Ladesäule schwenkbeweglich gelagert und grundsätzlich in der geschlossenen, die Ladeschnittstelle vor Zugriff schützenden Stellung gehaltert. Mittels elektronischer Schlüssel, insbesondere mittels sogenannter Tags oder Transponder, kann die Funktionsweise der Ladestation beeinflusst werden. Dabei ist einerseits ein Benutzer-Tag vorgesehen, mit welchem standardmäßige Benutzer die Ladefunktionalität der Ladesäule freischalten können. Zudem ist ein Service-Tag vorgesehen, mit welchem die Funktionalität einer digitalen Kommunikationsschnittstelle aktiviert werden kann, sodass diverse Service- bzw. Wartungsarbeiten durchgeführt werden können. Mittels einem sogenannten Stilllegungs-Tag kann die Ladestation für grundlegende, tiefgreifende Wartungsarbeiten stillgelegt werden. In Zusammenhang mit der Verwendung des Service-Tag ist vorgesehen, dass die Ladestation in einen Servicemodus versetzt werden kann. In diesem Servicemodus ist die Kommunikationsschnittstelle nur innerhalb oder für eine vorbestimmte Zeitspanne verfügbar bzw. freigeschaltet. Sofern nicht innerhalb der von einem sogenannten Time-Watchdog vorbestimmten Zeitspanne das externe Wartungs- und Programmiergerät zur Wartung und Programmierung der Ladestation daran angeschlossen wird, wird nach entsprechendem Zeitablauf die Kommunikationsschnittstelle wieder deaktiviert und die Ladestation wieder in den Ladebereitschaftszustand versetzt (ready blue state), in welchem keine Spannung an der Ladeschnittstelle anliegt. Die Rücksetzung der Ladesäule erfolgt dabei unabhängig davon, ob die Schutzklappe geschlossen wurde oder nicht. Sofern die Schutzklappe geschlossen wurde, bevor der Zeitablauf eintritt, so wird die Ladestation in den Verwendungs-Bereitschaftszustand zurückversetzt und dies durch eine blau leuchtende Anzeige signalisiert. Der entsprechende Time-Watchdog ist dabei an das Kriterium des zeitgerechten Anschlusses eines externen Gerätes zur Wartung und Programmierung der Ladestation gekoppelt.

Die US 2010/013433 A1 bzw. die äquivalente, oben genannte WO 2010/011545 A1 beschreibt eine Ladestation für Elektrofahrzeuge, bei welcher die Ladeschnittstelle durch eine schwenkbar gelagerte Klappe vor Zugriff geschützt und freigegeben werden kann. In der geschlossenen Stellung der Klappe ist diese auch während eines Stromausfalls in der verriegelten Stellung gehalten. Durch Energiebeaufschlagung eines ersten Elektromagneten kann diese Verriegelungsvorrichtung entriegelt und die Klappe sodann durch einen Benutzer geöffnet werden. Zudem ist eine zweite Verriegelungsvorrichtung vorgesehen, mit welcher die Klappe in einer halb geöffneten Stellung gehalten werden kann. Diese halb geöffnete Stellung wird dabei durch aktive Energiebeaufschlagung eines zweiten Elektromagneten beibehalten.

Das Gehäuse solcher Ladeanschlussvorrichtungen muss dabei die hantierenden Personen vor dem Kontakt mit spannungsführenden Teilen im Innenraum bzw. vor lebensgefährlichen Stromschlägen schützen. Darüber hinaus schützt das Gehäuse die innenliegenden elektrischen und elektronischen Komponenten vor mechanischer Beschädigung sowie Schmutz und Feuchtigkeit und weiteren im Umfeld von Fahrzeugen zu erwartenden Stoffen, wie beispielsweise Streusalz oder vergleichbar wirkende Auftaumittel, und stellt damit deren dauerhaft zuverlässige Funktion sicher.

Die Ladestationen neuerer Art werden bereits als vergleichsweise kompakte Einheiten gefertigt, deren Funktion und Sicherheit vor der Auslieferung geprüft wird. Alle für die Funktion und Sicherheit der Einheit relevanten Komponenten sind in diesem geschlossenen Gehäuse angeordnet und damit vor Beschädigung oder Manipulation geschützt. Üblicherweise sind auch nur die Anschlussklemmen für den Anschluss an das Stromnetz und gegebenenfalls Schnittstellen für eine Anbindung an Kommunikationsnetze über separat abnehmbare Gehäuseteile für den mit der Installation und Inbetriebnahme betrauten Fachmann zugänglich. Dieser ist verantwortlich für die ordnungsgemäße Installation bzw. Montage und den Anschluss an das Stromnetz.

Die Installation wird in der Regel von Elektromonteuren vorgenommen, welche eine allgemeine Befähigung und Berechtigung zur Durchführung von Elektroinstallationen haben. Der Fachmann, der solche Elektroinstallationen durchführt, ist in der Regel gesetzlich dazu verpflichtet, eine Anlageninbetriebnahme durchzuführen und diese auch zu protokollieren - beispielsweise in Deutschland nach DIN VDE 0100/0413 oder nach jeweils vergleichbaren länderspezifischen Vorschriften. Dabei ist vom Elektromonteur im Zusammenhang mit den genannten Ladestadonen die Funktion, vor allem aber auch der sichere Betrieb zu überprüfen. Die dabei vom Elektromonteur durchzuführenden Prüfungen entsprechen im Wesentlichen jenen, die auch für herkömmliche Haushalts- und Starkstromsteckdosen durchzuführen sind, für welche am Markt standardisierte Installationsprüfer von diversen Anbietern verfügbar und allgemein verbreitet sind.

Die entsprechend den derzeit geltenden einschlägigen Sicherheitsnormen ausgestalteten Ladestationen schalten die Netzspannung an die Steckverbindung für den Anschluss eines Elektrofahrzeuges jedoch nur dann frei, wenn zuvor die Herstellung der elektrischen und/oder mechanischen Verbindung zu dem Elektrofahrzeug festgestellt wurde, d.h. das Anstecken an ein entsprechendes Gegenstück zur fest installierten Steckverbindung und/oder der Aufbau einer Kommunikationsverbindung zur Ladeelektronik des Fahrzeuges und dessen Ladebereitschaft von der Ladestation geprüft und festgestellt wurde. Die derzeit üblichen Installationsprüfer für Haushalts- und Starkstromsteckdosen können daher für die Inbetriebnahmeprüfung von Ladestationen nach dem aktuellen Stand der Technik nicht verwendet werden.

Die Inbetriebnahme und Prüfung dieser Ladestationen erfordert daher die Verwendung spezieller Prüfeinrichtungen, welche den Anschluss eines Elektrofahrzeuges simulieren und damit die Netzspannung an der Abgabeschnittstelle der Ladestation während des Prüfvorganges freischalten. Eine solche Simulations- und Prüfeinrichtung entsprechend dem Stand der Technik ist in der WO 2011/031801 A2 beschrieben. Die technische Komplexität und der Aufwand für derartige Prüfeinrichtungen sind jedoch relativ hoch, wodurch sie nur eine eingeschränkte Marktakzeptanz besitzen. Hinzu kommt ein erheblicher Kostenfaktor bei der Anschaffung einer solchen speziellen Prüfeinrichtung für Elektromonteure, welche möglicherweise nur wenige Ladestationen pro Jahr installieren und in Betrieb nehmen.

Der vorliegenden Erfindung liegt die Aufgabe zugrunde, eine Ladeanschlussvorrichtung für Elektrofahrzeuge zu schaffen, welche gute Voraussetzungen für eine umfassende Verbreitung am Markt besitzt, insbesondere eine hohe Wirtschaftlichkeit bietet.

Diese Aufgabe der Erfindung wird durch eine Ladeanschlussvorrichtung entsprechend den Merkmalen in Anspruch 1 gelöst. Ein besonderer Vorteil der erfindungsgemäßen Lösung liegt darin, dass eine geschulte bzw. fachkundige Bedienperson, in der Regel ein Elektromonteur, unter Einhaltung einschlägiger Sicherheitsmaßnahmen die Ladespannung, welche üblicherweise der Netzspannung des Stromversorgungsnetzes entspricht, an der Ladeschnittstelle der Ladeanschlussvorrichtung freischalten kann, ohne dass ein Elektrofahrzeug oder ein spezieller Adapter bzw. ein spezielles Simulations- und Testgerät, welches den Anschluss eines Elektrofahrzeuges simuliert, angeschlossen werden muss. Insbesondere ist es durch die erfindungsgemäßen Maßnahmen ermöglicht, dass die Bedienperson nach einer bewusst initiierten Einleitung des Prüfmodus an der Ladeanschlussvorrichtung beispielsweise mit herkömmlichen, standardmäßig verfügbaren bzw. üblicherweise vorhandenen Prüfspitzen die Ladeschnittstelle entsprechend kontaktieren und das Vorliegen der ordnungsgemäßen bzw. geforderten Zustände messen bzw. überprüfen kann. Die Anschaffung eines speziell für Ladestationen konzipierten Testadapters, welcher den korrekten Anschluss eines Elektrofahrzeuges simuliert und gleichzeitig die an der Ladeschnittstelle bereitzustellende Ladespannung zugänglich macht, oder welcher Testadapter entsprechende integrierte Testschaltungen aufweist, wird dadurch in vorteilhafter Art und Weise erübrigt. Zusätzliche Initialkosten bzw. Investitionen für die Durchführung einschlägiger Inbetriebnahme- bzw. Sicherheits-Tests vermindern sich dadurch in Verbindung mit der erfindungsgemäßen Ladeanschlussvorrichtung wesentlich, sodass sich der Personen- bzw. Unternehmenskreis, welcher solche Installationen mitsamt den entsprechenden Inbetriebnahme-Tests durchführen kann, grundsätzlich vergrößert. Insbesondere tragen die erfindungsgemäßen Maßnahmen dazu bei, dass die erfindungsgemäße Ladeanschlussvorrichtung eine möglichst umfassende Verbreitung am Markt erzielen kann, wodurch positive wirtschaftliche Aspekte für den Produzenten, für den Elektroinstallateur und auch für den Anwender der angegebenen Ladeanschlussvorrichtung erzielt werden können.

Ein besonderer Vorteil der erfindungsgemäßen Maßnahmen liegt auch darin, dass dadurch die Wahrscheinlichkeit bzw. Gefahr von nicht oder nicht ausreichend getestet installierten Ladeanschlussvorrichtungen für Elektrofahrzeuge gesenkt bzw. eliminiert werden kann. Nachdem für eine Inbetriebnahme der erfindungsgemäßen Ladeanschlussvorrichtung keine erhöhten Kosten für spezielle Simulations- bzw. Testgeräte erforderlich sind, ist nämlich das Risiko bzw. die Gefahr, dass solche Installationen ungetestet oder nicht ausreichend getestet in Betrieb gehen, deutlich reduziert bzw. nahezu auszuschließen. Somit wird durch die erfindungsgemäßen Maßnahmen auch zur Erzielung einer hohen, allgemeinen Betriebs- bzw. Bedienungssicherheit beigetragen. Auch dieser zusätzliche Sicherheitsaspekt kann die Marktverbreitung unterstützen und damit einen wirtschaftlichen Vorteil für die Produzenten, die Elektroinstallateure und auch für die Endanwender bedeuten.

Durch die erfindungsgemäßen Maßnahmen ist darüber hinaus sichergestellt, dass die Netz- bzw. Ladespannung nur innerhalb einer begrenzten Zeitspanne nach einer bewussten Aktivierung des nur zu Test- bzw. Prüfzwecken vorgesehenen Prüfmodus an der Ladeschnittstelle freigeschaltet ist. Diese Zeitspanne ist dabei derart bemessen, dass sie für die Überprüfung der Installation üblicherweise ausreichend ist. Durch diese vordefmierte Zeitspanne wird in zuverlässiger und effektiver Art und Weise verhindert, dass bei einem nicht ordnungsgemäß beendeten Inbetriebnahmetest die Netz- bzw. Ladespannung über einen längeren bzw. über einen unbeschränkten Zeitraum an der im Wesentlichen frei bzw. leicht zugänglichen Ladeschnittstelle anliegt. Insbesondere wird durch die angegebenen Maßnahmen sowohl eine potentielle Gefährdung von Personen, als auch ein potentieller Missbrauch, d.h. ein nicht autorisierter Ladevorgang bzw. ein nicht vorgesehener Strombezug, zuverlässig verhindert.

Von Vorteil sind auch die Maßnahmen gemäß Anspruch 2, da dadurch eine einfache und effiziente Absicherung des Prüfmodus der Ladeanschlussvorrichtung gegen versehentliche und/oder unbefugte Aktivierung erzielt ist. Von Vorteil ist weiters, dass die hohen Sicherheitsanforderungen an eine gattungsgemäße Ladeanschlussvorrichtung im Zuge eines planmäßigen Betriebs und der ordnungsgemäßen Bedienung weiterhin erfüllt bleiben. Insbesondere bleibt gewährleistet, dass an der Ladeschnittstelle der Ladeanschlussvorrichtung im Zuge der Einnahme der Ladebereitschaft, d.h. ohne einem angeschlossenen Elektrofahrzug, keine lebensgefährlichen Spannungen anliegen. Insbesondere wird trotz der erfindungsgemäß implementierten Maßnahmen die entsprechende Ladespannung im regulären Betriebsmodus erst dann auf die Ladeschnittstelle freigeschaltet, wenn der ordnungsgemäße Anschluss eines ladebereiten Elektrofahrzeuges detektiert wurde. Das heißt, dass trotz der erfindungsgemäßen Weiterbildung der Ladeanschlussvorrichtung gewährleistet ist, dass der Zugriff auf Teile bzw. Abschnitte, welche lebensgefährliche Spannungen führen, zuverlässig unterbunden ist und eine Freischaltung der Ladespannung, welche üblicherweise der Netzspannung entspricht, nur im kontrollierten und planmäßigen Zusammenspiel mit der Ladeelektronik eines Elektrofahrzeuges stattfindet.

Durch die Maßnahmen nach Anspruch 3 ist in vorteilhafter Art und Weise sichergestellt, dass eine Aktivierung des Prüfmodus nur bei geöffnetem Gehäuse bzw. bei abgenommener Serviceabdeckung ermöglicht ist. Eine versehentliche oder unbefugte Aktivierung des Prüfmodus durch den Endanwender, insbesondere im Zuge des gewöhnlichen, ordnungsgemäßen Gebrauchs, kann dadurch nahezu ausgeschlossen werden. Die mit der Ladeanschlussvorrichtung erzielbare Betriebs- bzw. Bedienungssicherheit kann dadurch weiter gesteigert werden.

Von Vorteil sind auch die Maßnahmen nach Anspruch 4, da dadurch ein Anschlussfach bzw. Servicebereich für den Inbetriebnahme-Techniker geschaffen ist, in welchem alle für die Installation bzw. Inbetriebnahme erforderlichen Zugriffe örtlich konzentriert sind. Dadurch kann zum einen die Installation vereinfacht bzw. die erforderliche Installationszeit verkürzt werden. Darüber hinaus wird dadurch aber auch vermieden bzw. hintan gehalten, dass die installierende Fachkraft bzw. der Elektromonteur auf Bereiche bzw. Komponenten der Ladeanschlussvorrichtung, beispielsweise auf die elektronische Steuervorrichtung, Zugriff hat, welche relativ empfindlich ist bzw. keine für den Elektromonteur relevanten Komponenten bzw. Einstellelemente besitzt. Insbesondere wird dadurch das Handling und auch die Robustheit bzw. Funktionszuverlässigkeit der Ladeanschlussvorrichtung verbessert. Aber auch die Fehler- bzw. Störungsanfälligkeit wird durch diese positionsmäßige Zusammenlegung bzw. durch diese benachbarte Anordnung der Anschlussklemmen für die Zuleitung und des Schaltelementes verbessert. Eine spezielle, eigenständige Abdichtung des Schaltelementes gegen Eindringen von Schmutz und Feuchtigkeit wird erübrigt, da das Schaltelement vollständig im Inneren des Gehäuses angeordnet ist und durch die ohnedies erforderliche und vorhandene Abdichtung des Gehäuses geschützt ist.

Von Vorteil sind auch die Maßnahmen nach Anspruch 5, da dadurch einer Vielzahl von Zuständen bzw. Kriterien, welche für einen sicheren Betrieb bzw. Ablauf der Ladeanschlussvorrichtung berücksichtigt werden sollten, in praktikabler Art und Weise Rechnung getragen werden kann. Vor allem kann dadurch die Systemsicherheit bzw. die Fehler- oder Betriebssicherheit der Ladeanschlussvorrichtung verbessert werden. Insbesondere kann in Verbindung mit der Steuervorrichtung im Vergleich zu einer direkten Durch- bzw. Aufschaltung der Ladespannung auf die Ladeschnittstelle eine besonders kontrollierte bzw. eine zustandsabhängige Einleitung des Prüfmodus vorgenommen werden. Insbesondere kann dadurch dem benutzerinitiierten Befehl bzw. Wunsch zur Aktivierung des Prüfmodus quasi eine künstliche Steuerungsintelligenz überlagert werden und in diese benutzerseitige Anforderung einfließen. Dadurch kann die Gesamtfunktionalität der Ladeanschlussvorrichtung weiter verbessert werden.

Vorteilhaft sind auch die Maßnahmen gemäß Anspruch 6 bzw. 7, da dadurch sichergestellt ist, dass der Prüfmodus nur durch eine aktive Bedienhandlung einleitbar ist und nicht dauerhaft aktiviert ist. Insbesondere kann dadurch auch nach einem Wegfall und der Wiederherstellung der eingangsseitigen Stromversorgung via das Stromversorgungsnetz eine unbeabsichtigte und potentiell sicherheitskritische Fortführung des Prüfmodus ausgeschlossen werden.

Ferner sind die weiterbildenden Maßnahmen gemäß Anspruch 8 von Vorteil, da dadurch die Überwachung des ordnungsgemäßen Anschlusses eines Elektrofahrzeuges im Zuge eines Ladebetriebs und die Ab- bzw. Wegschaltung der Ladespannung beim Nicht-Vorliegen eines ordnungsgemäßen Anschlusses besonders zuverlässig implementiert werden kann. Insbesondere ist dadurch die Sicherheit erhöht bzw. die Funktions- und Personensicherheit unabhängig vom Laufzeitverhalten und von potentiellen Fehlern von Softwarekomponenten der funktionalen Steuervorrichtung gewährleistet.

Von Vorteil sind auch die Maßnahmen gemäß Anspruch 9. Dadurch ist sichergestellt, dass die Überwachungsschaltung direkt bzw. unmittelbar durch eine bewusst vorgenommene Aktivierung des Prüfmodus deaktiviert bzw. inaktiv ist und nicht etwa durch einen Softwarefehler der funktionalen Steuervorrichtung deaktivierbar ist. Dadurch kann eine hohe Systemsicherheit der Ladeanschlussvorrichtung gewährleistet werden.

Vorteilhaft sind weiters die Vorkehrungen gemäß Anspruch 10. Damit ist sichergestellt, dass der Prüfmodus bzw. die Testfunktion nicht für die versehentliche oder missbräuchliche Durchführung eines Ladevorganges genutzt werden kann. Sicherheitskritische Zustände oder Schäden können dadurch vermieden bzw. hintan gehalten werden.

Aber auch eine Ausbildung nach Anspruch 11 ist von Vorteil. Dadurch kann im Zuge eines solchen Selbsttests bzw. einer automatisiert ablaufenden Überprüfungsroutine der Ladeanschlussvorrichtung z.B. die Funktion einer eventuell vorhandenen, elektrisch verstellbaren Verriegelungsvorrichtung für die Anschlussbuchse der Ladeschnittstelle geprüft werden. Alternativ oder in Kombination dazu können die Spannungen an allen Phasen eines mehrphasigen Stromnetzanschlusses und/oder das Ansprechen integrierter Stromwandler bzw. Strommesseinrichtungen und/oder die Ansteuerung eines Hauptschützen zum Freischalten der Ladespannung an der Ladeschnittstelle und dgl. automatisiert auf Funktionstüchtigkeit überprüft werden. Dabei wird die Ladespannung an der Ladeschnittstelle erst dann freigeschaltet, wenn die von der Ladeanschlussvorrichtung automatisch überprüfbaren Voraussetzungen für einen ordnungsgemäßen und sicheren Betrieb erfolgreich verifiziert sind. Sodann sind von einer fachkundigen Bedienperson weitere Tests unter Zuhilfenahme üblicher Hilfsmittel, insbesondere Prüfmittel und Messgeräte, durchführbar. Auch dadurch kann die System- bzw. Betriebssicherheit der Ladeanschlussvorrichtung erheblich verbessert bzw. gesteigert werden.

Es ist aber auch eine Weiterbildung nach Anspruch 12 von Vorteil. Insbesondere kann dadurch sichergestellt werden, dass bei frei- bzw. durchgeschalteter Netz- bzw. Ladespannung ein An- bzw. Abstecken eines kompatiblen elektrischen Steckers in Bezug auf die Ladeschnittstelle unterbunden ist, wodurch die Gefahr einer Lichtbogenbildung auszuschließen ist. Wesentlich ist dabei, dass durch diese gesteuert aktivier- und deaktivierbare Verriegelungsvorrichtung zur Steckerblockierung die elektrischen Kontakte der Ladeschnittstelle auch im gesperrten Zustand, d.h. im aktiven Zustand der Verriegelungsvorrichtung mit üblichen Prüfmitteln zugänglich sind bzw. mit herkömmlichen Prüfspitzen kontaktierbar bleiben und nicht abgedeckt werden. Durch die automatisiert eingeleitete Verriegelung wird dabei lediglich ein An- und Abstecken eines zur Anschluss- bzw. Steckbuchse der Ladeschnittstelle passenden Steckers verhindert, während sich die Ladeanschlussvorrichtung im Prüfmodus befindet.

Zweckmäßig ist auch eine vorteilhafte Ausbildung nach Anspruch 13, da dadurch sichergestellt ist, dass während des für eine Erstinbetriebnahme vorgesehenen Prüfmodus kein versehentlicher oder missbräuchlicher Ladevorgang stattfinden kann. Sicherheitskritische Zustände oder Schäden können dadurch vermieden bzw. hintan gehalten werden.

Von Vorteil sind auch die Maßnahmen nach Anspruch 14. Zu bedenken ist dabei, dass eine Auslösung der sicherheitsrelevanten Fehlerstromüberwachung und die Überprüfung der zuverlässigen Abschaltung ein wesentlicher und üblicherweise abschließender Teil einer Überprüfung ist, welche im Zuge der Inbetriebnahme der Ladeanschlussvorrichtung von einer geschulten Bedienperson bzw. Fachkraft durchzuführen ist. Durch die gleichzeitige Beendigung des Prüfmodus nach einer Auslösung der Fehlerstromüberwachung ist sichergestellt, dass nach einem manuellen oder automatischen Rücksetzen der ausgelösten Fehlerstromabschaltung die Netz- bzw. Ladespannung erst wieder durch eine bewusste Aktivierung des Prüfmodus auf die Ladeschnittstelle aufgeschaltet wird. Eine erneute bzw. selbsttätige, potentiell gefährdende Aufschaltung der Netz- bzw. Ladespannung auf die Ladeschnittstelle ist dadurch verhindert.

Durch die vorteilhaften Maßnahmen gemäß Anspruch 15 wird die maximal abgegebene Leistung bzw. der maximal abgebbare Strom bei Einnahme des Prüfmodus auf einen vergleichsweise kleinen Wert begrenzt, während er im Ladebetriebsmodus bzw. im Ladebereitschaftsmodus beispielsweise bis zu 22 kW oder 32 A betragen kann. Somit kann das prinzipielle Ansprechen einer integrierten Überstromüberwachung bzw. Überstromabschaltung mit einem geringeren Prüfstrom geprüft werden, als dem typen- bzw. installationsbedingten maximal möglichen Ladestrom. Die Netz- und Komponentenbelastung wird dadurch gering gehalten. Außerdem verringern sich dadurch die Anforderungen an die erforderlichen Testeinrichtungen bzw. an die Testlast sehr markant. Diese Vorteile sind insbesondere dann erzielbar, wenn die Strommessung durch sensorische Strommesseinrichtungen, insbesondere durch Stromwandler, erfolgt und eine Überstromabschaltung mittels eines in die Ladeanschlussvorrichtung integrierten Hauptschütz steuerungstechnisch vorgenommen wird.

Durch die Weiterbildung nach Anspruch 16 ist in vorteilhafter Art und Weise sichergestellt, dass nach einer werksseitigen Auslieferung einer Ladeanschlussvorrichtung ein regulärer Ladebetrieb erst dann möglich ist, bzw. von der integrierten Steuervorrichtung erst dann durchgeführt wird, wenn zuvor zumindest einmal der Prüfmodus aktiviert wurde. Auch dadurch kann die Systemsicherheit und die Betriebssicherheit verbessert werden.

Von Vorteil sind auch die Maßnahmen nach Anspruch 17, da damit sichergestellt werden kann, dass nach einer werksseitigen Auslieferung der Ladeanschlussvorrichtung ein regulärer Ladebetrieb erst dann möglich ist bzw. von der integrierten Steuervorrichtung erst dann durchgeführt wird, wenn zuvor zumindest einmal die Fehlerstromüberwachung erfolgreich ausgelöst wurde bzw. erfolgreich angesprochen hat.

Schließlich sind auch die Maßnahmen gemäß Anspruch 18 von Vorteil. Insbesondere kann dadurch sichergestellt werden, dass der nur für Zwecke der Inbetriebnahme vorgesehene Prüfmodus als entsprechende Sonderbetriebsart deutlich wahrgenommen wird. Insbesondere kann dadurch auch verhindert werden, dass die fachkundige Bedienperson bzw. der Elektromonteur nach Abschluss der Tests auf die Rücknahme von zur Aktivierung des Prüfmodus gegebenenfalls erforderlicher Modifikationen vergisst und damit der Prüfmodus bestehen bleibt bzw. ein regulärer Ladevorgang damit unterbunden bleibt.

Die Aufgabe der Erfindung wird auch durch die Maßnahmen gemäß Anspruch 19 gelöst. Die damit erzielbaren technischen Wirkungen und vorteilhaften Effekte sind den vorhergehenden Beschreibungsteilen zu entnehmen.

Zum besseren Verständnis der Erfindung wird diese anhand der nachfolgenden Figuren näher erläutert.

Es zeigen jeweils in vereinfachter, beispielhafter Darstellung:
- Fig. 1: ein Aufladesystem umfassend eine Elektrofahrzeug und eine daran anschließbare, erfindungsgemäß betriebene Ladeanschlussvorrichtung;
- Fig. 2: die Ladeanschlussvorrichtung gemäß Fig. 1 in perspektivischer Ansicht auf die Gehäuserückseite;
- Fig. 3: die Ladeanschlussvorrichtung gemäß Fig. 1 in Explosionsdarstellung;
- Fig. 4: ein stark abstrahiertes Blockschaltbild von der Steuervorrichtung der Ladeanschlussvorrichtung.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind diese Lageangaben bei einer Lageänderung sinngemäß auf die neue Lage zu übertragen.

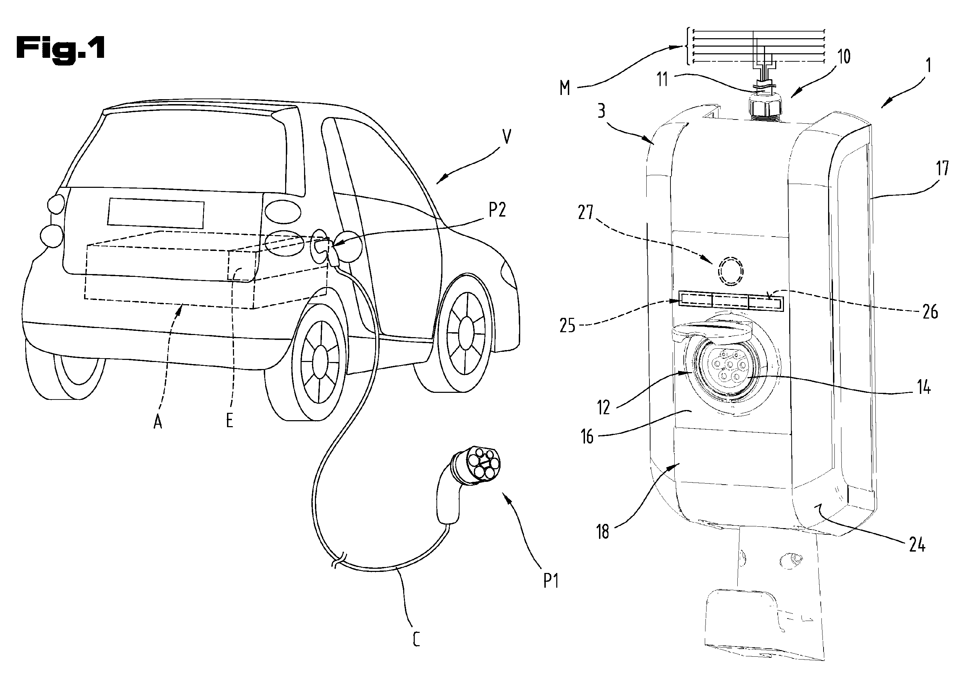

In den Fig. 1 bis 4 ist eine Ausführungsform einer Ladeanschlussvorrichtung 1 für Elektrofahrzeuge V veranschaulicht, welche Ladeanschlussvorrichtung 1 erfindungsgemäß betrieben werden kann bzw. welche erfindungsgemäße Kontroll- und Steuerungsabläufe ausführen kann. Diese Ladeanschlussvorrichtung 1 ist zum Aufladen bzw. Regenerieren des Energiespeichers A eines elektrisch betreibbaren Fahrzeuges vorgesehen, indem die Ladeanschlussvorrichtung 1 mit dem Energiespeicher A bzw. der Ladeelektronik E des Elektrofahrzeuges elektrisch verbunden wird. Die Ladeanschlussvorrichtung 1 ist dabei als Bezugsquelle für elektrische Energie zu verstehen, über welche elektrische Energie in den wenigstens einen Energiespeicher A eines Elektrofahrzeuges V übertragen werden kann. Die Ladeanschlussvorrichtung 1 stellt vor allem dann, wenn die Ladeelektronik E fahrzeugseitig eingebaut ist, eine Art von intelligenter Stromtankstelle für Elektrofahrzeuge V dar. Gegebenenfalls ist es auch möglich, der Ladeanschlussvorrichtung 1 eine Ladeelektronik zuzuordnen bzw. in die Ladeanschlussvorrichtung 1 eine Ladeelektronik zu integrieren, welche die eingangsseitig eingespeiste, elektrische Energie in eine für die Aufladung des Energiespeichers A im Elektrofahrzeug V adäquate bzw. angepasste Form umwandelt und bereitstellt.

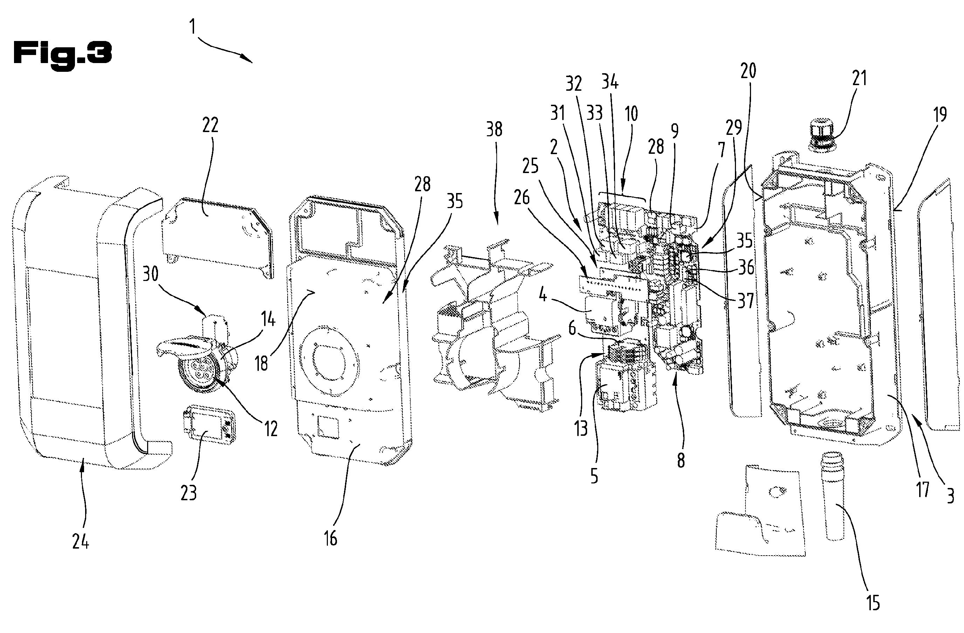

Wie am besten aus Fig. 3 ersichtlich ist, umfasst die Ladeanschlussvorrichtung 1 eine Mehrzahl von elektrotechnischen Komponenten 2, welche von einem mehrteiligen Gehäuse 3 umschlossen sind. Unter diesen elektrotechnischen Komponenten 2 sind auch elektronische Komponenten bzw. Baugruppen zu verstehen. Die elektrotechnischen Komponenten 2 dienen dabei zum Schalten und/oder Verteilen und/oder Messen und/oder Überwachen der aufgenommenen und/oder der abgegebenen, elektrischen Energie. Die elektrotechnischen Komponenten 2 können je nach Ausführungsform der Ladeanschlussvorrichtung 1 wenigstens eine Komponente ausgewählt aus der Bauteilgruppe umfassend Schütz 4, FI-Schutzschalter bzw. Fehlerstrom-Überwachungsvorrichtung 5, Relais, Anschlussklemme 6, elektronischer Schaltkreis und dergleichen umfassen. Zu den elektrotechnischen Komponenten 2 zählen also auch elektronische Baugruppen. Die elektrotechnischen Komponenten 2 umfassen dabei zumindest eine sogenannte Printplatte bzw. Leiterplatte 7, auf welcher eine Mehrzahl von elektronischen Bauelementen zum Steuern und/oder Messen und/oder Überwachen der Energiezustände an der Ladeanschlussvorrichtung 1 bzw. im damit verbindbaren Elektrofahrzeug V angeordnet sind. Insbesondere ist eine Steuer- und/oder Auswertevorrichtung vorgesehen - im nachfolgenden kurz Steuervorrichtung 8 genannt - welche zumindest teilweise auf einer Leiterplatte 7 ausgebildet ist. Gegebenenfalls kann die Steuervorrichtung 8 wenigstens eine datentechnische Kommunikationsschnittstelle 9 - Fig. 3 - umfassen, über welche eine datentechnische Kommunikation der Steuervorrichtung 8 bzw. der Ladeanschlussvorrichtung 1 mit peripheren, elektronischen bzw. elektrotechnischen Einheiten ermöglicht ist. Alternativ oder zusätzlich zu einer drahtgebundenen Kommunikationsschnittstelle 9 ist es selbstverständlich auch möglich, auf Funktechnologie basierende Kommunikationsschnittstellen vorzusehen.

Die Ladeanschlussvorrichtung 1 weist wenigstens eine Eingangsschnittstelle 10 zur Zuführung bzw. Einspeisung von elektrischer Energie aus einem ortsfesten Stromversorgungsnetz M auf. Insbesondere wird der Ladeanschlussvorrichtung 1 via diese Eingangsschnittstelle 10 die zur Weiterleitung an ein angeschlossenes Elektrofahrzeug V benötigte, elektrische Energie zugeführt. Die Eingangsschnittstelle 10 ist dabei als Leitungsschnittstelle ausgeführt, welche vorzugsweise zum Anschluss von Kabeladern vorgesehen ist. Um die typischerweise benötigte, elektrische Leistung zur bzw. in die Ladeanschlussvorrichtung 1 übertragen zu können, sind zumeist Kabelquerschnitte zwischen 4 bis 16 mm² vorgesehen. Die Eingangsschnittstelle 10 fungiert somit als Anschlussstelle für eine elektrische Zuleitung 11 aus dem örtlich vorhandenen bzw. häuslichen Stromversorgungsnetz M. Die elektrische Energie wird dabei von einem einphasigen oder bevorzugt mehrphasigen Stromversorgungsnetz M mit standardisierter bzw. haushaltsüblicher Netzspannung bezogen, also beispielsweise im europäischen Raum in Höhe von 230 V AC bzw. 400 V AC. Beispielsgemäß erfolgt die Energiezuführung bzw. Stromzuleitung via wenigstens einen Durchbruch in der Gehäusedeckfläche der Ladeanschlussvorrichtung 1. Selbstverständlich ist es auch möglich, die Seitenwände bzw. die Rückwand und/oder die Bodenplatte des Gehäuses 3 mit wenigstens einer Kabeldurchführung für die elektrische Zuleitung 11 zu versehen.

Der elektrische Anschluss der Ladeanschlussvorrichtung 1 an das örtliche Stromversorgungsnetz M via die Zuleitung 11 ist dabei von einem Elektromonteur bzw. von einer Fachkraft vorzunehmen, welche über das entsprechende Fachwissen verfügt und die einschlägigen Sicherheitsbestimmungen kennt bzw. einhält.

Die Ladeanschlussvorrichtung 1 umfasst darüber hinaus wenigstens eine Ladeschnittstelle 12, 13 zur gesteuerten bzw. kontrollierten Abgabe von elektrischer Energie an ein daran angeschlossenes Elektrofahrzeug V. Diese zweite Schnittstelle 12, 13 umfasst dabei wenigstens eine Steckbuchse 14. Zudem können Anschlussklemmen 6 - Fig. 3 - für wenigstens einen fixen Kabelabgang 15 bzw. für die Kabelenden eines fix anschließbaren bzw. angeschlossenen Ladekabels (nicht dargestellt) ausgebildet sein. Insbesondere umfasst die zweite Schnittstelle 12 der Ladeanschlussvorrichtung 1 wenigstens eine Steckbuchse 14, an welche ein Ladekabel C mit einem korrespondierenden Stecker P1 bedarfsweise anschließbar und auf Wunsch von der Ladeanschlussvorrichtung 1 wieder lösbar bzw. abkuppelbar ist. Mittels dem Ladekabel C und dem daran angeschlossenen Stecker P1 kann die von der Ladeanschlussvorrichtung 1 bereitgestellte bzw. jeweils verfügbare elektrische Energie an ein damit verbundenes Elektrofahrzeug V übertragen werden. Am zweiten Ende des Ladekabels C kann ein Stecker P2 vorgesehen sein, welcher mit einer korrespondierenden Steckbuchse am Elektrofahrzeug V bedarfsweise kuppelbar ist, um eine elektrische Leitungsverbindung zwischen der Ladeanschlussvorrichtung 1 und der Ladeelektronik E bzw. dem Energiespeicher A im Elektrofahrzeug V aufbauen zu können. Anstelle eines Steckers P2 für eine bedarfsweise An- und Abkopplung des Ladekabels C gegenüber dem Elektrofahrzeug V ist es auch möglich, dass das Ladekabel C fix bzw. permanent mit dem Elektrofahrzeug V bzw. mit dessen Ladeelektronik E verbunden ist. Insbesondere kann ein fahrzeugseitig eingebauter Aufroll- bzw. Aufnahmemechanismus für eine platzsparende und bequeme Unterbringung des Ladekabels C im Elektrofahrzeug V sorgen, wenn der Ladevorgang des Energiespeichers A abgeschlossen ist oder das Elektrofahrzeug V in Bewegung gesetzt werden soll. Bei der dargestellten Ausführung ist ein optional vorgesehener Kabelabgang 15 der Ladeanschlussvorrichtung 1 mit einer Kabelhalterung - Fig. 1,3- kombiniert, um eine geordnete Halterung von Restlängen bzw. der Gesamtlänge des Verbindungs- bzw. Ladekabels C zu einem Elektrofahrzeug V zu ermöglichen.

Um die elektrotechnischen Komponenten 2 möglichst rasch bzw. einfach im Gehäuse 3 unterbringen bzw. einbauen zu können, ist es zweckmäßig, wenn das Gehäuse 3 aus wenigstens einem ersten Gehäuseteil 16 und aus wenigstens einem weiteren Gehäuseteil 17 gebildet ist. Entsprechend der dargestellten, zweckmäßigen Ausführungsform ist das Gehäuse 3 als Wandgehäuse ausgeführt, wobei der erste Gehäuseteil 16 zumindest einen Teilabschnitt der Gehäusevorderseite 18 ausbildet und der weitere Gehäuseteil 17 zumindest einen Teilabschnitt der Gehäuserückseite 19 definiert. Das aus wenigstens einem ersten, beispielsgemäß frontseitigen Gehäuseteil 16 und aus wenigstens einem weiteren, beispielsgemäß rückseitigen Gehäuseteil 17 zusammengesetzte Gehäuse 3 stellt dabei in Verbindung mit wenigstens einem Abdichtungselement 20, 21 sicher, dass die darin eingebauten elektrotechnischen Komponenten 2 vor einer Berührung durch Personen sowie vor Feuchtigkeit und Schmutz geschützt sind. Gegebenenfalls kann - wie schematisch dargestellt - zumindest am ersten bzw. vorderen Gehäuseteil 16 wenigstens ein bedarfsweise lösbarer bzw. bedarfsweise aufklappbarer Deckel 22, 23 vorgesehen sein, mit welchem ein teilweiser Zugriff bzw. eine partielle Einsichtnahme in das Gehäuseinnere, beispielsweise auf einen FI-Schutzschalter 5 oder einen Leitungsschutzschalter, ermöglicht ist.

Weiters kann ein Verkleidungselement 24 vorgesehen sein, welches zumindest Teilabschnitte des festigkeitsrelevanten Gehäuses 3 überdeckt. Durch einfaches Abnehmen des relativ filigran ausgebildeten Verkleidungselementes 24 - Fig. 1 - vom festigkeitsrelevanten Grundgehäuse umfassend den ersten und den weiteren Gehäuseteil 16, 17 besteht dann uneingeschränkter Zugriff auf ein bevorzugt werkzeuglos verstellbares Klappen- bzw. Deckelelement 23 für die Betätigung oder Rückstellung einer Fehlerstrom-Überwachungsvorrichtung 5 in Form eines FI-Schutzschalters bzw. Zugriff auf einen durch Schrauben befestigten Deckel 22 zum örtlich begrenzten Zugriff auf ein Netzanschlussfach im Gehäuse 3 bzw. auf die Eingangsschnittstelle 10 mit den Anschlussklemmen für die elektrische Zuleitung 11 aus dem örtlichen Stromversorgungsnetz M. Die Deckel 22 und/oder 23 stellen dabei eine vorteilhafte, optionale Ausführung dar, um örtlich begrenzten Zugriff auf nur einen Teil der elektrotechnischen Komponenten 2, insbesondere auf die Anschlussklemmen der Eingangsschnittstelle 10 und/oder auf die Fehlerstrom-Überwachungsvorrichtung 5 zu erhalten, während die sonstigen elektrotechnischen Komponenten 2 der Ladeanschlussvorrichtung 1 weitgehend geschützt bzw. verdeckt bleiben. Es ist aber auch möglich, auf diese Deckel 22 und/oder 23 zu verzichten und durch Abnehmen bzw. Montieren des ersten Gehäuseteils 16 den Zugriff auf die elektrotechnischen Komponenten 2 im Gehäuse 3 für Personen, insbesondere für Fachkräfte zu regulieren.

Die Ladeanschlussvorrichtung 1 kann weiters wenigstens ein steuerungstechnisches Ausgabeelement 25 zur Signalisierung von Betriebszuständen der Ladeanschlussvorrichtung 1 bzw. zur Anzeige von Ladezuständen des Energiespeichers A im Elektrofahrzeug V bzw. zur Visualisierung von betriebsrelevanten Daten der Ladeanschlussvorrichtung 1 gegenüber einem Benutzer, insbesondere gegenüber einer Wartungs- bzw. Bedienperson aufweisen. Dieses wenigstens eine Ausgabeelement 25 umfasst hierfür wenigstens ein visuell wahrnehmbares, optisches Anzeigemittel 26, mit welchem einer Person diverse Betriebszustände, wie zum Beispiele Ladezustände, Ladezeiten, Ladefortschritte, Störungszustände, Auswahlmöglichkeiten, Quittierungsaufforderungen oder dergleichen mitgeteilt werden können.

Zusätzlich zur Ausbildung von wenigstens einem optischen bzw. visuell erfassbaren Ausgabeelement 25 ist es selbstverständlich auch möglich, wenigstens ein akustisch wahrnehmbares Ausgabeelement, beispielsweise einen Summer, Lautsprecher oder dergleichen vorzusehen, um die Interaktion bzw. die insgesamt mögliche Informationsübermittlung an eine Bedienperson oder eine sonstige Person zu erweitern. Anstelle oder zusätzlich zu einem Anzeigemittel 26 mit einer Mehrzahl von Leuchtdioden ist es selbstverständlich auch möglich, ausreichend lichtstarke 7-Segmentanzeigen oder sonstige Displays vorzusehen.

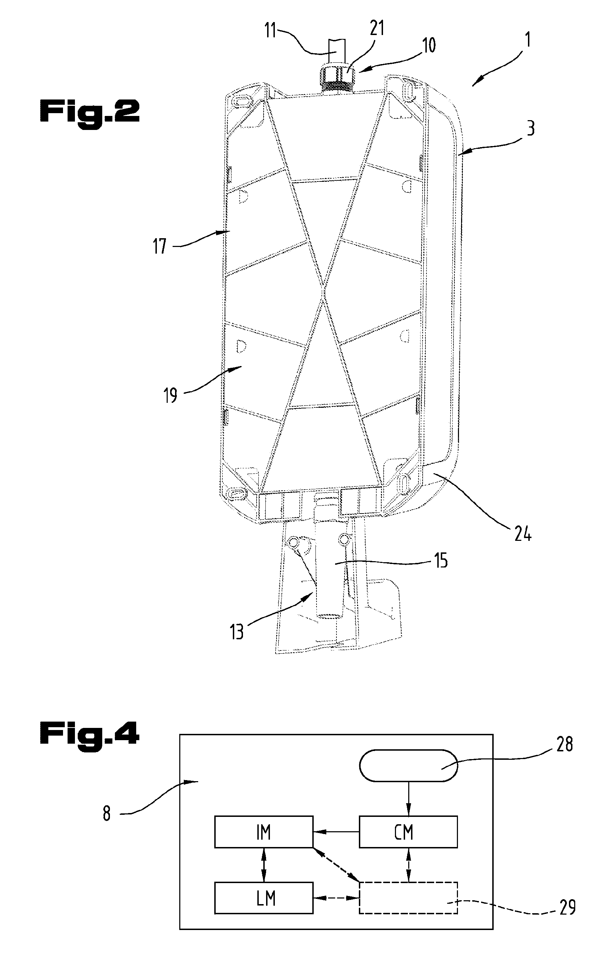

Entsprechend einer zweckmäßigen Ausgestaltung kann auch ein Signalisierungsmittel 27 ausgebildet sein, welches zur optischen und/oder akustischen Signalisierung des Vorliegens eines Prüfmodus CM (check mode) und/oder des Nicht-Vorliegens eines Ladebereitschaftsmodus IM (idle mode) der Ladeanschlussvorrichtung 1 vorgesehen ist, wie dies in Fig. 4 angedeutet und im Nachfolgenden im Detail erläutert wird.

Die internen Abläufe und die Betriebsweise der Ladeanschlussvorrichtung 1 werden primär durch die integrierte Steuervorrichtung 8 bestimmt bzw. mitbestimmt. Unter anderem ist dabei vorgesehen, dass die Ladeanschlussvorrichtung 1 bei Einnahme des Ladebetriebsmodus LM elektrische Energie an der Ladeschnittstelle 12, 13 bereitstellt. Insbesondere wird im Ladebetriebsmodus LM elektrische Energie an der Ladeschnittstelle 12, 13 freigeschaltet, wenn von der Steuervorrichtung 8 der Anschluss eines ladebereiten Elektrofahrzeuges V festgestellt wurde. Diese Überprüfung in Bezug auf den tatsächlichen Anschluss eines ladebereiten Elektrofahrzeuges V wird unter anderem von der Steuervorrichtung 8 vorgenommen, welche hierzu bevorzugt auch mit der Ladeelektronik E eines angeschlossenen Elektrofahrzeuges V kommuniziert bzw. automatisiert überprüft, ob ein adäquates Ladekabel C angeschlossen ist. In jenen Fällen bzw. zu jenen Zeitpunkten, bei welchen kein Elektrofahrzeug V angeschlossen ist, ist die Ladeschnittstelle 12, 13 bevorzugt energie- bzw. spannungslos geschaltet, was durch die Steuervorrichtung 8 und wenigstens einen Leistungsschalter, insbesondere den Schütz 4, bewerkstelligt wird. Diese Maßnahme erhöht die Sicherheit des Aufladesystems bzw. der Ladeanschlussvorrichtung 1.

Wesentlich ist, dass die Ladeanschlussvorrichtung 1 von einer Bedienperson in einen gesonderten Prüfmodus CM versetzbar ist, in welchem die elektrische Energie bzw. die Ladespannung auch ohne einem Anschluss eines Elektrofahrzeuges V auf die Ladeschnittstelle 12, 13 aufschaltbar ist bzw. durchgeschaltet wird. Demnach ist die Ladeanschlussvorrichtung 1 für Elektrofahrzeuge V derart konzipiert, dass sie einen ersten Betriebsmodus, insbesondere einen Ladebetriebsmodus LM aufweist, in welchem die Netz- bzw. Ladespannung an der Ladeschnittstelle 12, 13 erst dann freigeschaltet wird, wenn der ordnungsgemäße Anschluss eines ladebereiten Elektrofahrzeuges V festgestellt wurde. Die erfindungsgemäße Ladeanschlussvorrichtung 1 weist darüber hinaus einen gegen versehentliche oder unbefugte Aktivierung abgesicherten und - insbesondere zu Testzwecken im Zuge der Inbetriebnahme - von einer geschulten Bedienperson bei Bedarf aktivierbaren, zweiten Betriebsmodus, insbesondere den Prüfmodus CM auf, in welchem die Netz- bzw. Ladespannung an der Ladeschnittstelle 12, 13 auch bei nicht vorliegendem Anschluss eines Elektrofahrzeuges V auf die Ladeschnittstelle 12, 13 frei- bzw. durchschaltbar ist. Durch die erfindungsgemäße Lösung kann eine geschulte bzw. fachkundige Bedienperson - in der Regel ein Elektromonteur - unter Einhaltung einschlägiger Sicherheitsmaßnahmen die Netz- bzw. Ladespannung an der Ladeschnittstelle 12, 13 freischalten - und zwar ohne, dass ein Elektrofahrzeug V oder ein spezieller Adapter bzw. ein Testgerät erforderlich wäre, welches den Anschluss eines Elektrofahrzeuges simuliert. Die Bedienperson bzw. Fachkraft kann dann mit herkömmlichen Prüfspitzen die Ladeschnittstelle 12, 13 kontaktieren und die Installation auf Sicherheit, auf ordnungsgemäße Betriebszustände und auf Korrektheit des Anschlusses überprüfen. Insbesondere kann dadurch ohne spezielle Prüf- bzw. Testgeräte das Vorliegen einer plangemäßen Installation, umfassend beispielsweise die Prüfung der Netzspannung, das Vorliegen sämtlicher Phasen eines mehrphasigen Stromversorgungsnetzes M, die Auslösung einer in die Ladeanschlussvorrichtung 1 integrierten oder einer der Ladeanschluss 1 vorgeschalteten Fehlerstrom-Überwachungsvorrichtung 5, und dergleichen, überprüft werden. Die erfindungsgemäßen Maßnahmen tragen dabei zu einer wesentlichen Vereinfachung und zu einer deutlich wirtschaftlicheren Installationsüberprüfung bei, ohne dadurch Sicherheitsrichtlinien zu verletzen.

Insbesondere entfällt durch die erfindungsgemäße Lösung ein erhöhter Investitionsaufwand für zusätzliche Testeinrichtungen bzw. in entsprechende Testadapter, welche sich für allgemeine Elektromonteure, die nur vergleichsweise selten Aufladesysteme der beschriebenen Art installieren und in Betrieb nehmen, nur schwer rechnen. Daraus resultierte in der Vergangenheit eine gewisse Gefahr, dass solche Installationen ungetestet oder nicht ausreichend getestet in Betrieb gehen, nachdem für eine ordnungsgemäße Inbetriebnahme erhöhte Kosten angefallen sind.

Die erfindungsgemäße Lösung schafft hier Abhilfe, da die angegebene Ladeanschlussvorrichtung 1 für Elektrofahrzeuge V, die im Normalbetrieb zwar sicherstellt, dass die Netz- bzw. Ladespannung nur bei einem ordnungsgemäß angeschlossenen Elektrofahrzeug V an der Ladeschnittstelle 12, 13 freigeschaltet wird, welche jedoch auch einen sicheren, im Zuge der Inbetriebnahme aktivierbaren Test- bzw. Prüfmodus CM aufweist, der die vorübergehende Freischaltung der Netz- bzw. Ladespannung zur Durchführung von Inbetriebnahmetests ermöglicht.

Entsprechend einer vorteilhaften Ausführungsform ist vorgesehen, dass dieser Prüfmodus CM durch Betätigung oder Aktivierung eines im Inneren des Gehäuses 3 der Ladeanschlussvorrichtung 1 angeordneten Schaltelementes 28 - Fig. 3 - bei Bedarf aktivierbar ist. Entsprechend einer zweckmäßigen Maßnahme kann dabei vorgesehen sein, dass das Schaltelement 28 durch Öffnen des Gehäuses 3 oder durch Abnahme von wenigstens einem Gehäuseteil 16 oder Deckel 22 zugreifbar ist.

Zweckmäßig kann es dabei auch sein, das Schaltelement 28 in einem Nahbereich zu Anschlussklemmen für die elektrische Zuleitung 11 aus dem öffentlichen Stromversorgungsnetz M zu positionieren, wie dies in Fig. 3 beispielhaft veranschaulicht wurde. Insbesondere ist es vorteilhaft, wenn die Anschlüsse für die elektrische Zuleitung 11 und das Schaltelement 28 in einem sogenannten Netzanschlussfach bzw. Servicebereich für eine Elektrofachkraft untergebracht sind.

Entsprechend einer vorteilhaften Maßnahme kann dieses Schaltelement 28 mit einem Steuereingang der Steuervorrichtung 8 verbunden sein. Die jeweilige Schaltstellung bzw. der entsprechende Schaltzustand des Schaltelementes 28 kann dann von der Steuervorrichtung 8 ausgewertet bzw. detektiert werden. Dadurch ist eine steuerungstechnische Erfassung von bediener- bzw. benutzerseitigen Instruktionen umgesetzt, wobei auch eine Reihe von Zuständen bzw. Kriterien evaluiert und berücksichtigt werden können. Dabei kann vorgesehen sein, dass die Ladeanschlussvorrichtung 1 einen im Inneren des Gehäuses 3 angeordneten Anschlussbereich vorweist, welche im Zuge der Installation - beispielsweise für die Herstellung des netzseitigen elektrischen Anschlusses zugänglich ist. Hingegen ist im späteren, ordnungsgemäßen Ladebetrieb der Zugriff auf das Schaltelement 28 durch eine angebrachte Abdeckung bzw. durch den Deckel 22 unterbunden.

Das Schaltelement 28 kann durch ein beliebiges, elektrotechnisches Bedien- bzw. Konfigurationselement definiert sein. Das Schaltelement 28 kann insbesondere in Art eines Schalters, eines Tasters oder einer konfigurierbaren Drahtbrücke ausgeführt sein. Ebenso ist es denkbar, einen sogenannten DIP-Switch vorzusehen. Wesentlich ist, dass durch Betätigung oder Modifizierung dieses Schaltelementes 28 der Prüfmodus CM der Ladeanschlussvorrichtung 1 zumindest vorübergehend aktivierbar ist.

Entsprechend einer weiterbildenden Maßnahme kann vorgesehen sein, dass nach dem Aufschalten von elektrischer Energie auf die Eingangsschnittstelle 10 der Ladeanschlussvorrichtung 1 - welche elektrische Energie aus dem Stromversorgungsnetz M stammt - die Steuervorrichtung 8 einen Betriebsmodus für Ladebereitschaft, insbesondere einen Ladebereitschaftsmodus IM, einnimmt und dabei unabhängig von der Stellung oder vom Schaltzustand des Schaltelementes 28 die Einnahme des Prüfmodus CM unterbunden ist. Dies erbringt weitere sicherheitstechnische Verbesserungen.

Ebenso kann vorgesehen sein, dass nach dem Aufschalten von elektrischer Energie aus dem Stromversorgungsnetz M auf die Eingangsschnittstelle 10 der Ladeanschlussvorrichtung 1, die Steuervorrichtung 8 einen Betriebsmodus für Ladebereitschaft, insbesondere einen Bereitschaftsmodus IM einnimmt und die Steuervorrichtung 8 erst durch eine bewusste Betätigung oder Aktivierung des Schaltelementes 28 die Einnahme des Prüfmodus CM initiiert.

Gemäß einer zweckmäßigen Maßnahme kann auch eine Überwachungsschaltung 29 ausgebildet sein, welche unabhängig von der eigentlichen, funktionalen Steuervorrichtung 8 arbeitet. Diese Überwachungsschaltung 29 ist dabei zur Ermittlung bzw. Überprüfung des Anschlusses eines Elektrofahrzeuges V ausgebildet. Die eigenständig arbeitende bzw. unabhängig auswertende Überwachungsschaltung 29 kann dennoch eine gemeinsame Baueinheit mit der Steuervorrichtung 8 ausbilden bzw. als Teilkomponente der Steuervorrichtung 8 verstanden werden, wie dies aus den Fig. 3, 4 ersichtlich ist. Die Überwachungsschaltung 28 ist dabei derart konzipiert, dass sie eine Freischaltung der elektrischen Energie bzw. der Ladespannung auf die Ladeschnittstelle 12, 13 unterbindet, falls der Anschluss eines Elektrofahrzeuges V nicht verifizierbar ist. Diese Maßnahme verbessert vor allem die Fehlersicherheit der Steuerungsabläufe. In diesem Zusammenhang kann auch vorgesehen sein, dass für die Aktivierung des Prüfmodus CM die Modifizierung des Schaltelementes 28 oder einer entsprechenden Drahtbrücke erforderlich ist, wobei die unabhängig arbeitende Überwachungsschaltung 29 durch diese Modifikation bzw. Betätigung unmittelbar deaktiviert oder überbrückt wird.

Zudem kann vorgesehen sein, dass durch die Modifizierung bzw. Betätigung des Schaltelementes 28 bzw. einer dementsprechenden Drahtbrücke zur Einleitung des Prüfmodus CM die Ausführung eines regulären Ladevorganges von der funktionalen Steuervorrichtung 8 unterbunden wird.

Entsprechend einer zweckmäßigen Maßnahme kann auch vorgesehen sein, dass bei Einnahme des Prüfmodus CM und noch vor der Freischaltung der elektrischen Energie bzw. Ladespannung auf die Ladeschnittstelle 12, 13 von der Steuervorrichtung 8 eine zumindest teilweise automatisierte Überprüfungsroutine bzgl. zumindest einem elektrischen Parameter oder bzgl. zumindest einer elektrotechnischen Komponente 2 ausgeführt wird. Diese Überprüfungsroutine bzw. dieser Selbsttest der Ladeanschlussvorrichtung 1 kann z.B. die Funktion einer evtl. vorhandenen Verriegelungsvorrichtung 30 - Fig. 3 - das ordnungsgemäße Vorliegen von elektrischen Spannungen an allen drei Phasen des Netzanschlusses, das Ansprechen integrierter Stromstärkendetektoren 31-34 bzw. entsprechender Strommesseinrichtungen, die Ansteuerung des Schütz 4 zum Freischalten der Netz- bzw. Ladespannung an der Ladeschnittstelle 12, 13, oder dgl. umfassen. Wesentlich ist in Verbindung mit dieser Überprüfungsroutine der Steuervorrichtung 8, dass die Freischaltung der elektrischen Energie bzw. Spannung auf die Ladeschnittstelle 12,13 nur dann erfolgt, wenn diese automatisch ablaufende Überprüfungsroutine keine unzulässigen Betriebsbedingungen und keine fehlerhafte Funktionsweise aufzeigt.

Entsprechend einer vorteilhaften Ausbildung der Ladeanschlussvorrichtung 1 kann eine gesteuerte bzw. kontrollierte Abziehbarkeit und Ansteckbarkeit des Steckers P1 eines Ladekabels C gegenüber der Steckbuchse 14 vorgesehen sein. Insbesondere dann, wenn die Ladeschnittstelle 12 durch eine Steckbuchse 14 für die temporäre Herstellung einer elektrischen Verbindung zu einem Elektrofahrzeug V gebildet ist, kann die Steckbuchse 14 eine elektrisch aktivier- und deaktivierbare Verriegelungsvorrichtung 30 umfassen. Durch diese gesteuert aktivier- und deaktivierbare Verriegelungsvorrichtung 30 ist das Herstellen und Aufheben einer elektrischen Steckverbindung, insbesondere das Einführen und/oder Abziehen eines Gegensteckers, insbesondere des elektrischen Steckers P1, kontrolliert unterbindbar - vor allem während der Prüfmodus CM aktiv ist. D.h., dass bei Einnahme des Prüfmodus CM die Verriegelungsvorrichtung 30 bevorzugt aktiviert ist, um währenddessen ein An- und Abstecken eines Steckers zu verhindern. Insbesondere kann durch diese gesteuerte Verriegelung das An- und Abstecken des zur Steckbuchse 14 passenden Gegensteckers verhindert werden, sodass unzulässige Betriebszustände bzw. kritische Situationen steuerungstechnisch vermieden werden.

Gemäß einer zweckmäßigen Maßnahme kann auch vorgesehen sein, dass von der Steuervorrichtung 8 bzw. der Überwachungsschaltung 29 bei Einnahme des Prüfmodus CM vor und/oder nach dem Freischalten der elektrischen Energie bzw. Ladespannung an der Ladeschnittstelle 12, 13 ein allfälliger Anschluss eines Elektrofahrzeuges V überprüft wird. In diesem Zusammenhang wird dann von der Steuervorrichtung 8 bzw. der Überwachungsschaltung 29 die Freischaltung der elektrischen Energie bzw. Ladespannung unterbunden bzw. unterbrochen, falls der Anschluss eines Elektrofahrzeuges V festgestellt wird.

Entsprechend einer zweckmäßigen, weiterführenden Maßnahme kann eine in das Gehäuse 3 der Ladeanschlussvorrichtung 1 integrierte Fehlerstrom-Überwachungsvorrichtung 5 ausgebildet sein. Diese Fehlerstrom-Überwachungsvorrichtung 5 kann dabei zusätzlich oder alternativ zu einem der Ladeanschlussvorrichtung 1 vorgeschalteten bzw. netzseitigen FI-Schutzschalter vorgesehen sein. Eine solche in das Gehäuse 3 integrierte Fehlerstrom-Überwachungsvorrichtung 5 kann dabei mit der Steuervorrichtung 8 signaltechnisch, insbesondere auswertungstechnisch, derart verbunden sein, dass im Falle von auftretenden Fehlerströmen bzw. im Falle einer Fehlerstromabschaltung dieser Umstand der Steuerungsvorrichtung 8 mitgeteilt bzw. signalisiert wird. Hierzu kann im einfachsten Fall ein sogenannter Hilfskontakt der Fehlerstrom-Überwachungsvorrichtung 5 genutzt werden. Jedenfalls dient die Fehlerstrom-Überwachungsvorrichtung 5, welche typischerweise in Form eines elektromechanischen FI-Schutzschalters ausgeführt ist, zur Abschaltung der elektrischen Spannung an der Ladeschnittstelle 12, 13 im Falle der Detektierung von unzulässig hohen Fehlerströmen. Weiters ist in diesem Zusammenhang vorgesehen, dass der Prüfmodus CM von der Steuervorrichtung 8 beendet wird, sobald von der Fehlerstrom-Überwachungsvorrichtung 5 ein Abschaltzustand detektiert wurde. Hierfür ist die genannte signal- bzw. zustandstechnische Koppelung zwischen der Fehlerstrom-Überwachungsvorrichtung 5 und der Steuervorrichtung 8 vorgesehen.

Außerdem kann entsprechend einer zweckmäßigen Maßnahme vorgesehen sein, dass die Steuervorrichtung 8 bzw. die Überwachungsschaltung 29 derart konzipiert ist, dass eine Zeitdauer bzgl. der Aktivierung des Prüfmodus CM begrenzt ist. D.h., dass nach Aktivierung des Prüfmodus CM infolge einer Betätigung oder Modifizierung des Schaltelementes 28 der Prüfmodus 10 nach Ablauf einer gewissen Zeit automatisch beendet wird. Diese Zeitdauer kann auf einen Wert von maximal 15 Minuten festgelegt sein. Vorzugsweise ist jedoch eine Zeitdauer von maximal 5 Minuten vorgesehen, in welcher der Prüfmodus 10 aktiv sein kann, bis er automatisch zurückgesetzt wird. Selbstverständlich ist es auch möglich, dass ein Elektromonteur, welcher den Prüfmodus CM bewusst einleiten kann, den Prüfmodus CM früher bzw. vorzeitig aktiv beenden kann, beispielsweise durch erneutes Betätigen des Schaltelementes 28.

Außerdem kann es zweckmäßig sein, wenn die Ladeanschlussvorrichtung 1 ein Überwachungsmittel 35 für die an der Ladeschnittstelle 12, 13 abgegebene elektrische Leistung und/oder für den abgegebenen Ladestrom umfasst. Dieses Überwachungsmittel 35 ist dabei zur Abschaltung der elektrischen Spannung an der Ladeschnittstelle 12, 13 für den Fall einer festgestellten Überschreitung eines vorgegebenen, maximal zulässigen Grenzwertes der abgegebenen elektrischen Leistung beziehungsweise des abgegebenen Ladestroms vorgesehen. Entsprechend einer zweckmäßigen Maßnahme kann dabei der maximal zulässige Grenzwert bei Einnahme des Prüfmodus CM auf einen Wert festgesetzt sein, der deutlich niedriger ist als der Grenzwert bei Einnahme des Ladebetriebsmodus LM oder der Ladebereitschaft IM. Das genannte Überwachungsmittel 35 kann dabei zumindest einen der zuvor genannten Stromdetektoren 31-34 umfassen und auf einer softwaretechnischen Auswertung durch die Steuervorrichtung 8 basieren.

Weiters kann vorgesehen sein, dass die Ladeanschlussvorrichtung 1 einen elektronischen Speicher 36 zur dauerhaften Speicherung einer Statusinformation aufweist. Diese Statusinformation dient zur dauerhaften Kennzeichnung einer zumindest einmaligen Aktivierung des Prüfmodus CM der Ladeanschlussvorrichtung 1. Wesentlich ist im Zusammenhang mit der vorzugsweise automatisierten Speicherung dieser Statusinformation, dass die Durchführung eines Ladevorganges gegenüber einem Elektrofahrzeug V durch die Steuervorrichtung 8 erst dann ermöglicht ist, wenn durch die gespeicherte Statusinformation eine vorangegangene, zumindest einmalige Aktivierung des Prüfmodus CM signalisiert ist.

Die Ladeanschlussvorrichtung 1 kann entsprechend einer zweckmäßigen Ausgestaltung auch einen elektronischen Speicher 37 zur dauerhaften Speicherung einer Statusinformation aufweisen, welche Statusinformation eine zumindest einmalige Auslösung der Fehlerstrom-Überwachungsvorrichtung 5 dauerhaft kennzeichnet. In Zusammenhang damit, kann die Steuervorrichtung 8 bzw. die Überwachungsschaltung 29 derart konzipiert sein, dass die Durchführung eines Ladevorganges gegenüber einem Elektrofahrzeug V erst dann ermöglicht ist, wenn durch die gespeicherte Statusinformation eine vorangegangene, zumindest einmalige Auslösung der Fehlerstrom-Überwachungsvorrichtung 5 signalisiert ist.

Entsprechend der beispielhaft veranschaulichten Ausführungsform kann im Innenraum des Gehäuses 3 auch ein Formkörper 38 - Fig. 3 - vorgesehen sein, der zur Erhöhung der Belastbarkeit bzw. Bruchfestigkeit des Gehäuses 3 beiträgt. Ein solcher Formkörper 38 weist eine Mehrzahl von Stützstegen auf und kann vor allem dann zweckmäßig sein, wenn zumindest eines der Gehäuseteile 16, 17 aus formgespritztem Kunststoff gebildet ist.

Für den Fachmann ist dabei klar erkennbar, dass die vorhergehend beschriebenen Maßnahmen und Abläufe durch die im Gehäuse 3 der Ladeanschlussvorrichtung 1 integrierte Steuervorrichtung 8 bzw. durch die elektronische Überwachungsschaltung 29 implementiert sind, insbesondere auf Basis von mit Software programmierten Abläufen umgesetzt werden können

Die Ausführungsbeispiele zeigen mögliche Ausführungsformen der Ladeanschlussvorrichtung 1 bzw. des damit umgesetzten Betriebsverfahrens, wobei an dieser Stelle bemerkt sei, dass die Erfindung nicht auf die speziell dargestellten Ausführungsformen derselben eingeschränkt ist, sondern vielmehr auch diverse Kombinationen der einzelnen Ausführungsdetails untereinander möglich sind und diese Variationsmöglichkeit aufgrund der Lehre zum technischen Handeln durch gegenständliche Erfindung im Können des auf diesem technischen Gebiet tätigen Fachmannes liegt. Es sind also auch sämtliche denkbaren Ausführungsvarianten, die durch Kombinationen einzelner Details der dargestellten und beschriebenen Ausführungsform möglich sind, vom Schutzumfang mit umfasst.

Der Ordnung halber sei abschließend darauf hingewiesen, dass zum besseren Verständnis des Aufbaus der Ladeanschlussvorrichtung 1 bzw. des Aufladesystems dieses bzw. dessen Bestandteile teilweise unmaßstäblich und/oder vergrößert und/oder verkleinert dargestellt wurden.

Die den eigenständigen erfinderischen Lösungen zugrundeliegende Aufgabe kann der Beschreibung entnommen werden.

Vor allem können die einzelnen in den Fig. 1-4 gezeigten Maßnahmen den Gegenstand von eigenständigen, erfindungsgemäßen Lösungen bilden. Die diesbezüglichen, erfindungsgemäßen Aufgaben und Lösungen sind den Detailbeschreibungen dieser Figuren zu entnehmen.

**Bezugszeichenaufstellung**

| | | | |
|---|---|---|---|
| 1 | Ladeanschlussvorrichtung | 36 | Speicher |
| 2 | elektrotechn. Komponenten | 37 | Speicher |
| 3 | Gehäuse | 38 | Formkörper |
| 4 | Schütz | | |
| 5 | Fehlerstrom-Überwachungsvorrichtung | A | Energiespeicher |
| | | C | Ladekabel |
| | | E | Ladeelektronik |
| 6 | Anschlussklemme | P1 | Stecker |
| 7 | Leiterplatte | P2 | Stecker |
| 8 | Steuervorrichtung | | |
| 9 | Kommunikationsschnittstelle | V | Elektrofahrzeug |
| 10 | Eingangsschnittstelle | M | Stromversorgungsnetz |
| | | CM | Prüfmodus (check mode) |
| 11 | Zuleitung | IM | Ladebereitschaftsmodus (idle |
| 12 | Ladeschnittstelle | | mode) |
| 13 | Ladeschnittstelle | LM | Ladebetriebsmodus (loading mode) |
| 14 | Steckbuchse | | |
| 15 | Kabelabgang | | |
| | | | |
| 16 | erstes Gehäuseteil | | |
| 17 | weiteres Gehäuseteil | | |
| 18 | Gehäusevorderseite | | |
| 19 | Gehäuserückseite | | |
| 20 | Abdichtungselement | | |
| | | | |
| 21 | Abdichtungselement | | |
| 22 | Deckel | | |
| 23 | Deckel | | |
| 24 | Verkleidungselement | | |
| 25 | | | |
| | Ausgabeelement | | |
| 26 | Anzeigemittel | | |
| 27 | Signalisierungsmittel | | |
| 28 | Schaltelement | | |
| 29 | Überwachungsschaltung | | |
| 30 | Verriegelungsvorrichtung | | |
| | | | |
| 31 | Stromstärkendetektor | | |
| 32 | Stromstärkendetektor | | |
| 33 | Stromstärkendetektor | | |
| 34 | Stromstärkendetektor | | |
| 35 | Überwachungsmittel | | |

## Patentansprüche

1. Ladeanschlussvorrichtung (1) für Elektrofahrzeuge (V), mit wenigstens einer Eingangsschnittstelle (10) zur Einspeisung von elektrischer Energie aus einem ortsfesten Stromversorgungsnetz (M) in die Ladeanschlussvorrichtung (1), mit wenigstens einer Ladeschnittstelle (12, 13) zur gesteuerten Abgabe von elektrischer Energie an ein Elektrofahrzeug (V), mit einer Mehrzahl von elektrotechnischen Komponenten (2) umfassend eine elektronische Steuervorrichtung (8) zum Schalten, Messen oder Überwachen der aufgenommenen und/oder der abgegebenen elektrischen Energie, und mit einem die elektrotechnischen Komponenten (2) umschließenden Gehäuse (3), wobei in einem Ladebetriebsmodus (LM) elektrische Energie an der Ladeschnittstelle (12, 13) freigeschaltet ist, wenn von der Steuervorrichtung (8) der Anschluss eines ladebereiten Elektrofahrzeuges (V) festgestellt wurde, **dadurch gekennzeichnet, dass** die Ladeanschlussvorrichtung (1) von einer Bedienperson in einen Prüfmodus (CM) versetzbar ist, in welchem die elektrische Energie ohne einem Anschluss eines Elektrofahrzeuges (V) oder eines speziellen Adapters bzw. eines speziellen Simulations- und Testgerätes, welches den Anschluss eines Elektrofahrzeuges (V) simuliert, auf die Ladeschnittstelle (12, 13) aufgeschaltet oder durchgeschaltet ist, wobei eine Zeitdauer der Aktivierung des Prüfmodus (CM) begrenzt ist, insbesondere auf maximal 15 Minuten, vorzugsweise auf maximal 5 Minuten begrenzt ist.

2. Ladeanschlussvorrichtung nach Anspruch 1, **dadurch gekennzeichnet, dass** der Prüfmodus (CM) durch Betätigung oder Aktivierung eines im Inneren des Gehäuses (3) der Ladeanschlussvorrichtung (1) angeordneten Schaltelementes (28) aktivierbar ist.

3. Ladeanschlussvorrichtung nach Anspruch 2, **dadurch gekennzeichnet, dass** das Schaltelement (28) durch Öffnen des Gehäuses (3) oder durch Abnahme von wenigstens einem Gehäuseteil (16) oder Deckel (22) zugreifbar ist.

4. Ladeanschlussvorrichtung nach Anspruch 2 oder 3, **dadurch gekennzeichnet, dass** das Schaltelement (28) in einem Nahbereich zu Anschlussklemmen für eine elektrische Zuleitung (11) aus dem örtlichen Stromversorgungsnetz (M) positioniert ist.

5. Ladeanschlussvorrichtung nach einem der Ansprüche 2 bis 4, **dadurch gekennzeichnet, dass** das Schaltelement (28) mit einem Steuereingang der Steuervorrichtung (8) verbunden ist.

6. Ladeanschlussvorrichtung nach einem der Ansprüche 2 bis 5, **dadurch gekennzeichnet, dass** nach dem Aufschalten von elektrischer Energie aus dem Stromversorgungsnetz (M) auf die Eingangsschnittstelle (10) der Ladeanschlussvorrichtung (1), die Steuervorrichtung (8) einen Betriebsmodus für Ladebereitschaft (IM) einnimmt und unabhängig von der Stellung oder vom Schaltzustand des Schaltelementes (28) die Einnahme des Prüfmodus (CM) unterbunden ist.

7. Ladeanschlussvorrichtung nach einem der Ansprüche 2 bis 6, **dadurch gekennzeichnet, dass** nach dem Aufschalten von elektrischer Energie aus dem Stromversorgungsnetz (M) auf die Eingangsschnittstelle (10) der Ladeanschlussvorrichtung (1), die Steuervorrichtung (8) einen Betriebsmodus für Ladebereitschaft (IM) einnimmt und durch Betätigung oder Aktivierung des Schaltelementes (28) die Steuervorrichtung (8) die Einnahme des Prüfmodus (CM) initiiert.

8. Ladeanschlussvorrichtung nach einem der vorhergehenden Ansprüche, **dadurch gekennzeichnet, dass** eine Überwachungsschaltung (29) ausgebildet ist, welche unabhängig von der Steuervorrichtung (8) arbeitet und zumindest zur Ermittlung oder Überprüfung des Anschlusses eines Elektrofahrzeuges (V) ausgebildet ist, und dass die Überwachungsschaltung (29) eine Freischaltung der elektrischen Energie auf die Ladeschnittstelle (12, 13) unterbindet, falls der Anschluss eines Elektrofahrzeuges (V) nicht verifizierbar ist.

9. Ladeanschlussvorrichtung nach Anspruch 8, **dadurch gekennzeichnet, dass** die Überwachungsschaltung (29) durch Betätigung oder Aktivierung des Schaltelementes (28) unmittelbar deaktiviert oder überbrückt ist.

10. Ladeanschlussvorrichtung nach einem der Ansprüche 2 bis 9, **dadurch gekennzeichnet, dass** durch Aktivierung oder Betätigung des Schaltelementes (28) die Ausführung eines Ladevorganges von der Steuervorrichtung (8) unterbunden wird.

11. Ladeanschlussvorrichtung nach einem der vorhergehenden Ansprüche, **dadurch gekennzeichnet, dass** bei Einnahme des Prüfmodus (CM) und noch vor der Freischaltung der elektrischen Energie auf die Ladeschnittstelle (12, 13) von der Steuervorrichtung (8) eine Überprüfungsroutine bezüglich zumindest einem elektrischen Parameter oder bezüglich zumindest einer elektrotechnischen Komponente (2) ausgeführt wird, und dass die Freischaltung der elektrischen Energie auf die Ladeschnittstelle (12, 13) nur dann erfolgt, wenn die Überprüfung keine unzulässigen Betriebsbedingungen und keine fehlerhafte Funktionsweise aufzeigt.

12. Ladeanschlussvorrichtung nach einem der vorhergehenden Ansprüche, **dadurch gekennzeichnet, dass** die Ladeschnittstelle (12) durch eine Steckbuchse (14) für die temporäre Herstellung einer elektrischen Verbindung zu einem Elektrofahrzeug (V) gebildet ist, welche Steckbuchse (14) eine elektrisch aktivier- und deaktivierbare Verriegelungsvorrichtung (30) umfasst, durch welche das Herstellen und Aufheben einer elektrischen Steckverbindung, insbesondere das Einführen oder Abziehen eines elektrischen Steckers (P1), gesteuert unterbindbar ist, und dass bei Einnahme des Prüfmodus (CM) die Verriegelungsvorrichtung (30) aktiviert ist.

13. Ladeanschlussvorrichtung nach einem der vorhergehenden Ansprüche, **dadurch gekennzeichnet, dass** bei Einnahme des Prüfmodus (CM) noch vor und/oder nach dem Freischalten der elektrischen Energie an der Ladeschnittstelle ein allfälliger Anschluss eines Elektrofahrzeuges (V) überprüft wird und die Freischaltung der elektrischen Energie unterbunden beziehungsweise unmittelbar unterbrochen wird, falls der Anschluss eines Elektrofahrzeuges (V) festgestellt wird.

14. Ladeanschlussvorrichtung nach einem der vorhergehenden Ansprüche, **dadurch gekennzeichnet, dass** sie eine in das Gehäuse (3) integrierte Fehlerstrom-Überwachungsvorrichtung (5) aufweist, welche im Falle von Fehlerströmen zur Abschaltung der elektrischen Spannung an der Ladeschnittstelle (12, 13) ausgebildet ist, und dass der Prüfmodus (CM) beendet wird, sobald von der Fehlerstrom-Überwachungsvorrichtung (5) ein Abschaltzustand detektiert ist.

15. Ladeanschlussvorrichtung nach einem der vorhergehenden Ansprüche, **dadurch gekennzeichnet, dass** ein Überwachungsmittel (35) für die an der Ladeschnittstelle (12, 13) abgegebene elektrische Leistung und/oder für den abgegebenen Ladestrom ausgebildet ist, welches Überwachungsmittel (35) zur Abschaltung der elektrischen Spannung an der Ladeschnittstelle (12, 13) für den Fall einer festgestellten Überschreitung eines vorgegebenen, maximal zulässigen Grenzwertes der abgegebenen elektrischen Leistung beziehungsweise des abgegebenen Ladestroms vorgesehen ist, und dass der maximal zulässige Grenzwert bei Einnahme des Prüfmodus (CM) auf einen Wert festgesetzt ist, der deutlich niedriger ist als der Grenzwert bei Einnahme des Ladebetriebsmodus (LM) oder des Ladebereitschaftsmodus (IM).

16. Ladeanschlussvorrichtung nach einem der vorhergehenden Ansprüche, **dadurch gekennzeichnet, dass** sie einen elektronischen Speicher (36) zur dauerhaften Speicherung einer Statusinformation aufweist, welche Statusinformation eine zumindest einmalige Aktivierung des Prüfmodus (CM) dauerhaft kennzeichnet, und dass die Durchführung eines Ladevorganges gegenüber einem Elektrofahrzeug (V) durch die Steuervorrichtung (8) erst dann ermöglicht ist, wenn durch die gespeicherte Statusinformation eine vorangegangene, zumindest einmalige Aktivierung des Prüfmodus (CM) signalisiert ist.

17. Ladeanschlussvorrichtung nach einem der vorhergehenden Ansprüche, **dadurch gekennzeichnet, dass** sie einen elektronischen Speicher (37) zur dauerhaften Speicherung einer Statusinformation aufweist, welche Statusinformation eine zumindest einmalige Auslösung einer Fehlerstrom-Überwachungsvorrichtung (5) dauerhaft kennzeichnet, und dass die Durchführung eines Ladevorganges gegenüber einem Elektrofahrzeug (V) durch die Steuervorrichtung (8) erst dann ermöglicht ist, wenn durch die gespeicherte Statusinformation eine vorangegangene, zumindest einmalige Auslösung der Fchlerstrom-Überwachungsvorrichtung (5) signalisiert ist.

18. Ladeanschlussvorrichtung nach einem der vorhergehenden Ansprüche, **dadurch gekennzeichnet, dass** sie ein Signalisierungsmittel (27) aufweist, welches zur optischen oder akustischen Signalisierung des Vorliegens des Prüfmodus (CM) und/oder des Nicht-Vorliegens eines Ladebereitschaftsmodus (IM) vorgesehen ist.

19. Verfahren zum Betreiben einer Ladeanschlussvorrichtung (1) für Elektrofahrzeuge (V), mit wenigstens einer Eingangsschnittstelle (10) zur Einspeisung von elektrischer Energie aus einem ortsfesten Stromversorgungsnetz (M) in die Ladeanschlussvorrichtung (1), mit wenigstens einer Ladeschnittstelle (12, 13) zur gesteuerten Abgabe von elektrischer Energie an ein Elektrofahrzeug (V), mit einer Mehrzahl von elektrotechnischen Komponenten (2) umfassend eine elektronische Steuervorrichtung (8) zum Schalten, Messen oder Überwachen der aufgenommenen und/oder der abgegebenen elektrischen Energie, und mit einem die elektrotechnischen Komponenten (2) umschließenden Gehäuse (3), wobei in einem Ladebetriebsmodus (LM) elektrische Energie an der Ladeschnittstelle (12, 13) freigeschaltet wird, wenn von der Steuervorrichtung (8) der Anschluss eines ladebereiten Elektrofahrzeuges (V) festgestellt wurde, **dadurch gekennzeichnet, dass** die Maßnahmen und Abläufe nach einem oder mehreren der vorhergehenden Ansprüche durch die im Gehäuse (3) integrierte Steuervorrichtung (8) auf Basis von mit Software programmierten Abläufen umgesetzt werden.

## Claims

1. Charge connecting device (1) for electric vehicles (V) with at least one input interface (10) for supplying electrical energy from an immovable power supply network (M) to the charge connecting device (1), with at least one charging interface (12, 13) for the controlled delivery of electrical energy to an electric vehicle (V), with a plurality of electrotechnical components (2) comprising an electronic control device (8) for switching, measuring or monitoring the electrical energy received or delivered, and with a housing (3) that surrounds the electrotechnical components (2), wherein in a charging mode (LM) electrical energy is able to flow at the charging interface (12, 13) when the control device (8) has detected the connection of an electric vehicle (V) that requires charging, **characterised in that** the charge connecting device (1) can be switched to a check mode (CM) by an operator, in which the electrical energy is able to flow to or through the charging interface (12, 13) without the connection of an electric vehicle (V) or a special adapter or a special simulation and testing device that simulates the connection of an electric vehicle (V), wherein the activation period of the check mode (CM) is limited, particularly to not more than 15 minutes, preferably not more than a 5 minutes.

2. Charge connecting device according to claim 1, **characterised in that** the check mode (CM) can be activated by operating or activating a switching element (28) arranged in the interior of the housing (3) of the charge connecting device (1).

3. Charge connecting device according to claim 2, **characterised in that** the switching element (28) is accessible by opening the housing (3) or by removing at least one housing part (16) or cover (22).

4. Charge connecting device according to claim 2 or 3, **characterised in that** the switching element (28) is positioned in an area close to connecting terminals for an electrical supply cable (11) from the local power supply network (M).

5. Charge connecting device according to any one of claims 2 to 4, **characterised in that** the switching element (28) is connected to a control input of the control device (8).

6. Charge connecting device according to any one of claims 2 to 5, **characterised in that** after switching to receive a supply of electrical energy from the power supply network (M) to the input interface (10) of the charge connecting device (1), the control device (8) goes to an operating mode for charging readiness (IM) and switching to the check mode (CM) is prevented irrespective of the position or switching state of the switching element (28).

7. Charge connecting device according to any one of claims 2 to 6, **characterised in that** after switching to receive a supply of electrical energy from the power supply network (M) to the input interface (10) of the charge connecting device (1), the control device (8) goes to an operating mode for charging readiness (IM) and initiates switching to the check mode (CM) through operation or activation of the switching element (28).

8. Charge connecting device according to any one of the preceding claims, **characterised in that** a monitoring circuit (29) is designed to work independently of the control device (8) and is configured at least to detect or check the connection of an electric vehicle (V), and that the monitoring circuit (29) blocks an activation of the flow of electrical energy to the charging interface (12, 13) if the connection of an electric vehicle (V) cannot be verified.

9. Charge connecting device according to claim 8, **characterised in that** the monitoring circuit (29) is immediately deactivated or bypassed by operating or activating the switching element (28).

10. Charge connecting device according to any one of claims 2 to 9, **characterised in that** the performance of a charging operation is prevented by the control device (8) upon activation or operation of the switching element (28).

11. Charge connecting device according to any one of the preceding claims, **characterised in that** when the check mode (CM) is active, and still before the flow of electrical energy to the charging interface (12, 13) has been enabled, a check routine in respect of at least one parameter or at least one electrotechnical component (2) is run by the control device (8), and that the flow of electrical energy to the charging interface (12, 13) is only permitted if the check does not detect any impermissible operating conditions or faulty functionality.

12. Charge connecting device according to any one of the preceding claims, **characterised in that** the charging interface (12) is formed by a socket (14) for the temporary establishment of an electrical connection with an electric vehicle (V), which socket (14) comprises an electrically activatable and deactivatable interlocking device (30), by which the establishment and cancellation of an electrical plugged connection, particularly the insertion or removal of an electric plug (P1) can be prevented in controlled manner, and that the interlocking device (30) is activated when the check mode (CM) is entered.

13. Charge connecting device according to any one of the preceding claims, **characterised in that** when the check mode (CM) is entered, any connection of an electric vehicle (V) is checked before and/or after the flow of electrical energy to the charging interface is enabled, and the enablement of the flow of electrical energy is blocked or immediately interrupted if the connection of an electric vehicle (V) is detected.

14. Charge connecting device according to any one of the preceding claims, **characterised in that** it includes a fault current monitoring device (5) integrated in the housing (3), which device is designed to shut off the electrical voltage at the charging interface (12, 13) if fault currents occur, and that the check mode (CM) is terminated as soon as a shutoff state is detected by the fault current monitoring device (5).

15. Charge connecting device according to any one of the preceding claims, **characterised in that** a monitoring means (35) is designed for the electrical power delivered and/or for the charge current delivered at the charging interface (12, 13), which monitoring means (35) is provided to shut off the electrical voltage at the charging interface (12, 13) in the event that a maximum permissible limit value for the delivered electrical power and/or the delivered charge current is determined to have been exceeded, and that the maximum permissible limit value when entering check mode (CM) is fixed at a value substantially lower than the limit value for entering charging mode (LM) or charging readiness mode (IM).

16. Charge connecting device according to any one of the preceding claims, **characterised in that** it includes an electronic memory (36) for permanent storage of status information, which status information permanently identifies an at least single activation of the check mode (CM), and that the performance of a charging operation with respect to an electric vehicle (V) is not enabled by the control device (8) until a preceding, at least single activation of the check mode (CM) has been indicated by the stored status information.

17. Charge connecting device according to any one of the preceding claims, **characterised in that** it includes an electronic memory (37) for permanent storage of status information, which status information permanently identifies an at least single activation of a fault current monitoring device (5), and that the performance of a charging operation with respect to an electric vehicle (V) is not enabled by the control device (8) until a preceding, at least single activation of the fault current monitoring device (5) has been indicated by the stored status information.

18. Charge connecting device according to any one of the preceding claims, **characterised in that** it includes a signalling means (27) which is provided to emit a visible or audible signal to indicate that the check mode (CM) is active and/or that a charging readiness mode (IM) is not active.

19. Method for operating a charge connecting device (1) for electric vehicles (V) with at least one input interface (10) for supplying electrical energy from an immovable power supply network (M) to the charge connecting device (1), with at least one charging interface (12, 13) for the controlled delivery of electrical energy to an electric vehicle (V), with a plurality of electrotechnical components (2) comprising an electronic control device (8) for switching, measuring or monitoring the electrical energy received and/or delivered, and with a housing (3) that surrounds the electrotechnical components (2), wherein in a charging mode (LM) electrical energy is able to flow at the charging interface (12, 13) when the control device (8) has detected the connection of an electric vehicle (V) that requires charging, **characterised in that** the steps and processes according to one or more of the preceding claims are implemented by the control device (8) integrated in the housing (3) on the basis of sequences that have been programmed with software.

## Revendications

1. Dispositif de connexion de charge (1) pour des véhicules électriques (V), avec au moins une interface d'entrée (10) pour l'introduction d'énergie électrique provenant d'un réseau d'alimentation électrique stationnaire (M) dans le dispositif de connexion de charge (1), avec au moins une interface de charge (12, 13) pour la distribution contrôlée d'énergie électrique à un véhicule électrique (V), avec une pluralité de composants électrotechniques (2) comprenant un dispositif de commande électronique (8) pour la commutation, la mesure ou la surveillance de l'énergie électrique absorbée et/ou distribuée, et avec un boîtier (3) entourant les composants électrotechniques (2), dans un mode de charge (LM), de l'énergie électrique étant libérée au niveau de l'interface de charge (12, 13) lorsque le dispositif de commande (8) a détecté la connexion d'un véhicule électrique (V) prêt à être chargé, **caractérisé en ce que** le dispositif de connexion de charge (1) peut être mis par un utilisateur dans un mode de test (CM), dans lequel l'énergie électrique, sans connexion d'un véhicule électrique (V) ou d'un adaptateur spécial ou d'un appareil spécial de simulation et de test, qui simule la connexion d'un véhicule électrique (V), est appliquée ou transmise à l'interface de charge (12, 13), la durée de l'activation du mode de test (CM) étant limitée, plus particulièrement à 15 minutes maximum, de préférence à 5 minutes maximum.

2. Dispositif de connexion de charge selon la revendication 1, **caractérisé en ce que** le mode de test (CM) peut être activé par l'actionnement ou l'activation d'un élément de commutation (28) disposé à l'intérieur du boîtier (3) du dispositif de connexion de charge (1).

3. Dispositif de connexion de charge selon la revendication 2, **caractérisé en ce que** l'élément de commutation (28) est accessible par l'ouverture du boîtier (3) ou par retrait d'au moins une partie du boîtier (16) ou du couvercle (22).

4. Dispositif de connexion de charge selon la revendication 2 ou 3, **caractérisé en ce que** l'élément de commutation (28) est disposé à proximité de bornes de connexion pour une conduite d'alimentation électrique (11) provenant du réseau d'alimentation électrique local (M).

5. Dispositif de connexion de charge selon l'une des revendications 2 à 4, **caractérisé en ce que** l'élément de commutation (28) est relié à une entrée de commande du dispositif de commande (8).

6. Dispositif de connexion de charge selon l'une des revendications 2 à 5, **caractérisé en ce que**, après l'application de l'énergie électrique provenant du réseau d'alimentation électrique (M) à l'interface d'entrée (10) du dispositif de connexion de charge (1), le dispositif de commande (8) adopte un mode d'attente de charge (IM) et, indépendamment de la position ou de l'état de commutation de l'élément de commutation (28), l'activation du mode de test (CM) est inhibée.

7. Dispositif de connexion de charge selon l'une des revendications 2 à 6, **caractérisé en ce que**, après l'application de l'énergie électrique provenant du réseau d'alimentation électrique (M) à l'interface d'entrée (10) du dispositif de connexion de charge (1), le dispositif de commande (8) adopte un mode d'attente de charge (IM) et l'actionnement ou l'activation de l'élément de commutation (28) permet au dispositif de commande (8) d'initier l'activation du mode de test (CM).

8. Dispositif de connexion de charge selon l'une des revendications précédentes, **caractérisé en ce qu'**un circuit de surveillance (29) est prévu, qui fonctionne indépendamment du dispositif de commande (8) et est conçu au moins pour la détermination et le contrôle de la connexion d'un véhicule électrique (V) et **en ce que** le circuit de surveillance (29) inhibe l'autorisation de l'énergie électrique en direction de l'interface de charge (12, 13) dans le cas où la connexion d'un véhicule électrique (V) n'est pas vérifiable.

9. Dispositif de connexion de charge selon la revendication 8, **caractérisé en ce que** le circuit de surveillance (29) est désactivé directement ou court-circuité par l'actionnement ou l'activation de l'élément de commutation (28).

10. Dispositif de connexion de charge selon l'une des revendications 2 à 9, **caractérisé en ce que** l'activation ou l'actionnement de l'élément de commutation (28) permet d'inhiber la réalisation d'un processus de charge par le dispositif de commande (8).

11. Dispositif de connexion de charge selon l'une des revendications précédentes, **caractérisé en ce que**, lors de l'activation du mode de test (CM) et avant l'autorisation de l'énergie électrique vers l'interface de charge (12, 13) par le dispositif de commande (8), une routine de contrôle concernant au moins un paramètre électrique ou concernant au moins un composant électrotechnique (2) est exécutée et **en ce que** l'autorisation de l'énergie électrique dans l'interface de charge (12, 13) n'a lieu que lorsque le contrôle ne montre aucune condition de fonctionnement inadmissible et aucun dysfonctionnement.

12. Dispositif de connexion de charge selon l'une des revendications précédentes, **caractérisé en ce que** l'interface de charge (12) est constituée d'un connecteur femelle (14) pour l'établissement d'une liaison électrique temporaire avec un véhicule électrique (V), ce connecteur femelle (14) comprenant un dispositif de verrouillage (30) activable et désactivable grâce auquel l'établissement et l'annulation d'une liaison électrique, plus particulièrement l'introduction ou l'extraction d'une prise électrique (P1), peut être inhibé de manière contrôlée et **en ce que**, lors de l'activation du mode de test (CM), le dispositif de verrouillage (30) est activé.

13. Dispositif de connexion de charge selon l'une des revendications précédentes, **caractérisé en ce que**, lors de l'activation du mode de test (CM), avant et/ou après l'autorisation de l'énergie électrique dans l'interface de charge, une connexion d'un véhicule électrique (V) est vérifiée et l'autorisation de l'énergie électrique est inhibée ou directement interrompue dans le cas où la connexion d'un véhicule électrique (V) est détectée.

14. Dispositif de connexion de charge selon l'une des revendications précédentes, **caractérisé en ce qu'**il comprend un dispositif de surveillance de courants de défaut (5) intégré dans le boîtier (3), qui, dans le cas de courants de défaut, est conçu pour couper la tension électrique au niveau de l'interface de charge (12, 13) et **en ce que** le mode de test (CM) est terminé dès qu'un état de coupure est détecté par le dispositif de surveillance de courants de défaut (5).

15. Dispositif de connexion de charge selon l'une des revendications précédentes, **caractérisé en ce qu'**un moyen de surveillance (35) pour la puissance électrique fournie au niveau de l'interface de charge (12,13) et/ou pour le courant de charge fourni est prévu, ce moyen de surveillance (35) étant conçu pour couper la tension électrique au niveau de l'interface de charge (12, 13) dans le cas d'un dépassement d'une valeur limite admissible maximale prédéterminée de la puissance électrique fournie ou du courant de charge fourni et **en ce que** la valeur limite maximale admissible est déterminée lors de l'activation du mode de test (CM) à une valeur qui est nettement inférieure à la valeur limite lors de l'activation du mode de charge (LM) ou du mode d'attente de charge (IM).

16. Dispositif de connexion de charge selon l'une des revendications précédentes, **caractérisé en ce qu'**il comprend une mémoire électronique (36) pour l'enregistrement durable d'une information d'état, cette information d'état caractérisant durablement une activation, au moins une fois, du mode de test (CM) et **en ce que** la réalisation d'un processus de charge vis-à-vis d'un véhicule électrique (V) par le dispositif de commande (8) n'est autorisée que lorsque l'information d'état enregistrée signale une activation précédente, au moins une fois, du mode de test (CM).

17. Dispositif de connexion de charge selon l'une des revendications précédentes, **caractérisé en ce qu'**il comprend une mémoire électronique (37) pour l'enregistrement durable d'une information d'état, cette information d'état caractérisant durablement un déclenchement, au moins une fois, d'un dispositif de surveillance de courants de défaut (5) et **en ce que** la réalisation d'un processus de charge vis-à-vis d'un véhicule électrique (V) par le dispositif de commande (8) n'est autorisée que lorsque l'information d'état enregistrée signale un déclenchement, au moins une fois, du dispositif de surveillance de courants de défaut (5).

18. Dispositif de connexion de charge selon l'une des revendications précédentes, **caractérisé en ce qu'**il comprend un moyen de signalisation (27) qui est prévu pour la signalisation optique ou acoustique de l'activation du mode de test (CM) et/ou de la non-activation d'un mode d'attente de charge (IM).

19. Procédé d'exploitation d'un dispositif de connexion de charge (1) pour des véhicules électriques (V), avec au moins une interface d'entrée (10) pour l'introduction d'énergie électrique provenant d'un réseau d'alimentation électrique stationnaire (M) dans le dispositif de connexion de charge (1), avec au moins une interface de charge (12, 13) pour la distribution contrôlée d'énergie électrique à un véhicule électrique (V), avec une pluralité de composants électrotechniques (2) comprenant un dispositif de commande électronique (8) pour la commutation, la mesure ou la surveillance de l'énergie électrique absorbée et/ou fournie, et avec un boîtier (3) entourant les composants électrotechniques (2), dans un mode de charge (LM), de l'énergie électrique étant autorisée au niveau de l'interface de charge (12, 13) lorsque le dispositif de commande (8) a détecté la connexion d'un véhicule électrique (V) prêt à être chargé, **caractérisé en ce que** les mesures et les processus selon l'une ou plusieurs des revendications précédentes sont mis en oeuvre par le dispositif de commande (8) intégré dans le boîtier (3) sur la base de processus programmés avec un logiciel.
